# EUROPEAN PATENT APPLICATION

(11) **EP 4 436 340 A1**
(43) Date of publication of application: **25.09.2024**
(21) Application number: 24165711.3
(22) Date of filing: 22.03.2024
(51) Int. Cl.: H10K 59/121, H10K 59/123

(54) **DISPLAY APPARATUS AND METHOD OF MANUFACTURING THE SAME**

(30) Priority: 24.03.2023 KR 20230039233; 01.06.2023 KR 20230071012
(71) Applicant: Samsung Display Co., Ltd., Yongin-si, Gyeonggi-do 17113 (KR)
(72) Inventor: SHIM, Donghwan, 17113 Yongin-si (KR); PARK, Kwangwoo, 17113 Yongin-si (KR); PARK, Hyemin, 17113 Yongin-si (KR); LEE, Eonjoo, 17113 Yongin-si (KR); LEE, Jinyong, 17113 Yongin-si (KR); JANG, Cheol, 17113 Yongin-si (KR); JO, Yongseon, 17113 Yongin-si (KR)
(74) Representative: Marks & Clerk LLP

(57) **Abstract**

A display apparatus includes: a first display element configured to emit light of a first color and including a first pixel electrode; a second display element configured to emit light of a second color different from the first color, and including a second pixel electrode; a third display element configured to emit light of a third color different from the first color and the second color, and including a third pixel electrode; a fourth display element configured to emit light of the first color and including a fourth pixel electrode; and a first connection line connecting the first pixel electrode and the fourth pixel electrode to each other, the first connection line directly contacting the first pixel electrode and the fourth pixel electrode.

## Description

### BACKGROUND

### 1. Field

Aspects of one or more embodiments relate to a display apparatus and a method of manufacturing the display apparatus.

### 2. Description of the Related Art

Recently, the various uses of display apparatuses has diversified. In addition, as display apparatuses have become relatively thinner and more lightweight, their ranges of uses has gradually expanded.

As the area occupied by an area that displays images in display apparatuses expands, various functions that are combined or associated with display apparatuses have been added. As alternatives for adding various functions, research has been carried out on display apparatuses having a region for various functions while displaying images.

The region for various functions while displaying images desirably maintains a relatively high transmittance for light, sound or the like to perform the function thereof. When a high transmittance is maintained in the region for various functions while displaying images, resolution may be relatively reduced.

The above information disclosed in this Background section is only for enhancement of understanding of the background and therefore the information discussed in this Background section does not necessarily constitute prior art.

### SUMMARY

Aspects of one or more embodiments include a display apparatus and a method of manufacturing the same, wherein a relatively high transmittance is maintained and a relatively high resolution is maintained.

Characteristics of embodiments according to the present disclosure are not limited to the characteristics mentioned above, and other characteristics that are not mentioned will be more clearly understood by those of ordinary skill in the art from the description of the disclosure.

Additional aspects will be set forth in part in the description which follows and, in part, will be apparent from the description, or may be learned by practice of the presented embodiments of the disclosure.

According to one or more embodiments, a display apparatus includes a first display element configured to emit light of a first color and including a first pixel electrode, a second display element configured to emit light of a second color different from the first color, and including a second pixel electrode, a third display element configured to emit light of a third color different from the first color and the second color, and including a third pixel electrode, a fourth display element configured to emit light of the first color and including a fourth pixel electrode, and a first connection line connecting the first pixel electrode and the fourth pixel electrode to each other, the first connection line being in direct contact with the first pixel electrode and the fourth pixel electrode.

According to some embodiments, in a plan view, an edge of the first connection line may surround an edge of the first pixel electrode and an edge of the fourth pixel electrode.

According to some embodiments, the first pixel electrode and the fourth pixel electrode may be on the first connection line.

According to some embodiments, the first connection line may include poly indium tin oxide.

According to some embodiments, the first connection line may cover the first pixel electrode and the fourth pixel electrode.

According to some embodiments, the display apparatus may further include a pixel-defining layer including an opening exposing at least a portion of each of the first to fourth display elements, directly contacting the first connection line partially, and including an inorganic material.

According to some embodiments, the display apparatus may further include a substrate including a first region and a second region adjacent to each other, a pixel circuit arranged in the second region and configured to drive the first display element and the fourth display element, a circuit connection line electrically connected to the pixel circuit and arranged to extend from the second region to the first region, and an inorganic insulating layer covering the circuit connection line and arranged to extend from the second region to the first region, wherein the first connection line may be on the inorganic insulating layer, and the first connection line, the first pixel electrode, and the fourth pixel electrode may be arranged in the first region.

According to some embodiments, the circuit connection line and the first connection line may each include a transparent conductive material.

According to some embodiments, the display apparatus may further include a fifth display element configured to emit light of the second color and including a fifth pixel electrode, and a second connection line connecting the second pixel electrode and the fifth pixel electrode to each other, wherein the first display element and the third display element may be arranged in a first direction, and the second display element and the fifth display element may be arranged in a second direction crossing the first direction.

According to some embodiments, the display apparatus may further include a sixth display element configured to emit light of the third color and including a sixth pixel electrode, and a third connection line connecting the third pixel electrode and the sixth pixel electrode to each other, wherein the third display element and the sixth display element may be arranged in the first direction.

According to one or more embodiments, a method of manufacturing a display apparatus includes forming a first display element configured to emit light of a first color and including a first pixel electrode, forming a second display element configured to emit light of a second color different from the first color, and including a second pixel electrode, forming a third display element configured to emit light of a third color different from the first color and the second color, and including a third pixel electrode, forming a fourth display element configured to emit light of the first color and including a fourth pixel electrode, and forming a first connection line by curing a first material layer, wherein the first connection line connects the first pixel electrode and the fourth pixel electrode to each other and is in contact with lower surfaces of the first pixel electrode and the fourth pixel electrode.

According to some embodiments, the forming of the first connection line may be performed before the first pixel electrode and the fourth pixel electrode are formed.

According to some embodiments, the first connection line may include a transparent conductive material.

According to some embodiments, the first material layer may include amorphous indium tin oxide.

According to some embodiments, the first connection line may include poly indium tin oxide.

According to some embodiments, the curing of the first material layer may be performed at temperature of 200 °C or more.

According to some embodiments, in a plan view, an edge of the first connection line may surround an edge of the first pixel electrode and an edge of the fourth pixel electrode.

According to some embodiments, the method may further include forming a substrate including a first region and a second region adjacent to each other, forming a pixel circuit arranged in the second region and configured to drive the first display element and the fourth display element, forming a circuit connection line electrically connected to the pixel circuit and arranged to extend from the second region to the first region, and forming an inorganic insulating layer covering the circuit connection line and arranged to extend from the second region to the first region, wherein the first connection line, the first pixel electrode, and the fourth pixel electrode may be arranged in the first region.

According to some embodiments, the forming of the circuit connection line may be performed before the forming of the first connection line.

According to some embodiments, the method may further include forming a fifth display element configured to emit light of the second color and including a fifth pixel electrode, and forming a second connection line connecting the second pixel electrode and the fifth pixel electrode to each other, wherein the first display element and the third display element may be arranged in a first direction, and the second display element and the fifth display element may be arranged in a second direction crossing the first direction.

According to some embodiments, the method may further include forming a pixel-defining layer including an opening exposing at least a portion of each of the first to fourth display elements, directly contacting the first connection line partially, and including an inorganic material.

At least some of the above and other features of the invention are set out in the claims.

These and/or other aspects will become more apparent and more readily appreciated from the following description of the embodiments, the accompanying drawings, and claims.

These general and specific aspects may be implemented by using a system, a method, a computer program, or a combination of a certain system, method, and computer program.

### BRIEF DESCRIPTION OF THE DRAWINGS

The above and other aspects, features, and characteristics of certain embodiments of the disclosure will be more apparent from the following description taken in conjunction with the accompanying drawings, in which:
FIG. 1 is a schematic perspective view of a display apparatus according to some embodiments;
FIG. 2 is a cross-sectional view of an example of a portion of the display apparatus in FIG. 1, taken along the line I-I' in FIG. 1 according to some embodiments;
FIG. 3 is an equivalent circuit diagram of a pixel circuit electrically connected to a display element according to some embodiments;
FIG. 4 is a schematic plan view of a display panel according to some embodiments;
FIG. 5 is a cross-sectional view of an example of a portion of the display panel in FIG. 4, taken along the line II-II' in FIG. 4 according to some embodiments;
FIG. 6 is a schematic enlarged plan view of a portion of a display panel according to some embodiments;
FIG. 7 is a cross-sectional view of an example of a portion of the display panel in FIG. 6, taken along the line III-III' in FIG. 6 according to some embodiments;
FIG. 8 is a cross-sectional view of an example of a portion of the display panel in FIG. 6, taken along the line III-III' in FIG. 6 according to some embodiments;
FIGS. 9A to 9I are schematic cross-sectional views sequentially showing a method of manufacturing a display apparatus according to some embodiments; and
FIGS. 10A to 101 are schematic plan views sequentially showing a method of manufacturing a display apparatus according to some embodiments.

### DETAILED DESCRIPTION

Reference will now be made in more detail to aspects of some embodiments, which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects of the present description. As used herein, the term "and/or" includes any and all combinations of one or more of the associated listed items. Throughout the disclosure, the expression "at least one of a, b or c" indicates only a, only b, only c, both a and b, both a and c, both b and c, all of a, b, and c, or any combination of a, b, and/or c.

As the disclosure allows for various changes and numerous embodiments, certain embodiments will be illustrated in the drawings and described in the written description. Effects and features of the disclosure, and methods for achieving them will be clarified with reference to embodiments described below in detail with reference to the drawings. However, the disclosure is not limited to the following embodiments and may be embodied in various forms.

Hereinafter, aspects of some embodiments will be described in more detail with reference to the accompanying drawings, wherein like reference numerals refer to like elements throughout and a repeated description thereof is omitted.

While such terms as "first" and "second" may be used to describe various elements, such elements must not be limited to the above terms. The above terms are used to distinguish one element from another.

The singular forms "a," "an," and "the" as used herein are intended to include the plural forms as well unless the context clearly indicates otherwise.

It will be understood that the terms "comprise," "comprising," "include" and/or "including" as used herein specify the presence of stated features or elements but do not preclude the addition of one or more other features or elements.

It will be further understood that, when a layer, region, or element is referred to as being "on" another layer, region, or element it can be directly or indirectly on the other layer, region, or element. That is, for example, intervening layers, regions, or elements may be present.

Sizes of elements in the drawings may be exaggerated or reduced for convenience of explanation. As an example, the size and thickness of each element shown in the drawings are arbitrarily represented for convenience of description, and thus, the disclosure is not necessarily limited thereto.

In the case where a certain embodiment may be implemented differently, a specific process order may be performed in the order different from the described order. As an example, two processes successively described may be simultaneously (or concurrently) performed substantially and performed in the opposite order.

In the present specification, "A and/or B" means A or B, or A and B. In the present specification, "at least one of A and B" means A or B, or A and B.

It will be understood that when a layer, region, or element is referred to as being "connected" to another layer, region, or element, it may be "directly connected" to the other layer, region, or element or may be "indirectly connected" to the other layer, region, or element with another layer, region, or element located therebetween. For example, it will be understood that when a layer, region, or element is referred to as being "electrically connected" to another layer, region, or element, it may be "directly electrically connected" to the other layer, region, or element or may be "indirectly electrically connected" to the other layer, region, or element with another layer, region, or element interposed therebetween.

The x-axis, the y-axis and the z-axis are not limited to three axes of the rectangular coordinate system, and may be interpreted in a broader sense. For example, the x-axis, the y-axis, and the z-axis may be perpendicular to one another, or may represent different orientations that are not perpendicular to one another.

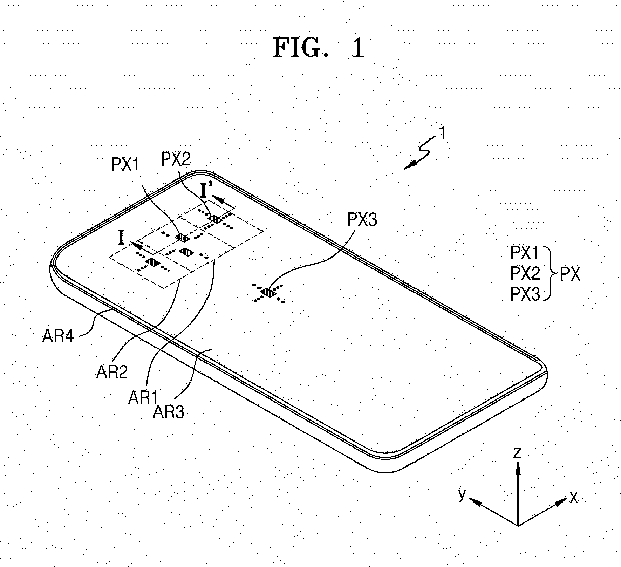

FIG. 1 is a schematic perspective view of a display apparatus 1 according to some embodiments.

Referring to FIG. 1, the display apparatus 1 may be configured to display images. The display apparatus 1 may include pixels PX. The pixel PX may be defined as a region through which a display element is configured to emit light. According to some embodiments, in the display apparatus 1, the pixel PX may be provided in plurality. Each of the plurality of pixels PX may be configured to emit light and display images. According to some embodiments, the pixels PX may include a first pixel PX1, a second pixel PX2, and a third pixel PX3. Hereinafter, in the present specification, each pixel PX denotes a sub-pixel configured to emit light of a different color. Each pixel PX may be, for example, one of a red sub-pixel, a green sub-pixel, and a blue sub-pixel.

The display apparatus 1 may include a first area AR1, a second area AR2, a third area AR3, and a fourth area AR4. The pixel PX may be arranged in the first area AR1, the second area AR2, and the third area AR3, which may be display areas. The pixel PX may not be arranged in the fourth area AR4, which may be a non-display area.

At least one of the first area AR1 or the second area AR2 may be a region overlapping a component, and simultaneously (or concurrently), a region in which the pixels PX are arranged. As an example, the first area AR1 may be a region overlapping the component, and simultaneously (or concurrently), a region in which the pixels PX are arranged. According to some embodiments, the first area AR1 and the second area AR2 may be regions overlapping the component, and simultaneously (or concurrently), regions in which the pixels PX are arranged. According to some embodiments, the first pixel PX1 may be arranged in the first area AR1. The second pixel PX2 may be arranged in the second area AR2. Accordingly, the first area AR1 and the second area AR2 may be regions configured to display images, and simultaneously (or concurrently), regions in which a component is arranged.

At least one of the first area AR1 or the second area AR2 may overlap a component. Accordingly, the display apparatus 1 may have to have a high transmittance of light or sound in the first area AR1 and the second area AR2. As an example, a light transmittance of the display apparatus 1 in at least one of the first area AR1 or the second area AR2, may be 10% or more, more preferably 25% or more, 40% or more, 50% or more, 85% or more, or 90% or more. According to some embodiments, a light transmittance of the display apparatus 1 in the first area AR1 may be greater than a light transmittance of the display apparatus 1 in the second area AR2.

According to some embodiments, the display apparatus 1 may include at least one first area AR1. As an example, the display apparatus 1 may include one first area AR1 or include a plurality of first areas AR1.

The second area AR2 may be arranged on one side of the first area AR1. As an example, the first area AR1 and the second area AR2 may be arranged side by side in an x direction or a -x direction. As another example, the first area AR1 and the second area AR2 may be arranged side by side in a y direction or a -y direction. According to some embodiments, the second area AR2 may be arranged on two opposite sides of the first area AR1.

According to some embodiments, although it is shown that the first area AR1 and the second area AR2 are arranged on the upper side in the display apparatus 1, the first area AR1 and the second area AR2 may be arranged on the lower side, right side, or left side in the display apparatus 1 according to some embodiments.

According to some embodiments, at least one of the first area AR1 or the second area AR2 may have various shapes such as a circular shape, an elliptical shape, a polygon including a quadrangle, a star shape, a diamond shape, or the like in a plan view (e.g., an x-y plane). It is shown in FIG. 1 that the first area AR1 and the second area AR2 each have a quadrangular shape.

The third area AR3 may surround at least a portion of the first area AR1 and the second area AR2. According to some embodiments, the third area AR3 may surround the first area AR1 and the second area AR2 entirely. According to some embodiments, the third area AR3 may surround only a portion of the first area AR1 and the second area AR2. The third pixel PX3 may be arranged in the third area AR3. According to some embodiments, the third area AR3 may be the display area. According to some embodiments, the resolution of the display apparatus 1 in the third area AR3 may be equal to or greater than the resolution of the display apparatus 1 in the first area AR1.

The fourth area AR4 may surround at least a portion of the third area AR3. According to some embodiments, the fourth area AR4 may surround the third area AR3 entirely. That is according to some embodiments, the fourth area AR4 may be outside a footprint or in a periphery of the first, second, and third areas AR1, AR2, and AR3. The pixel PX may not be arranged in the fourth area AR4. According to some embodiments, the fourth area AR4 may be the non-display area.

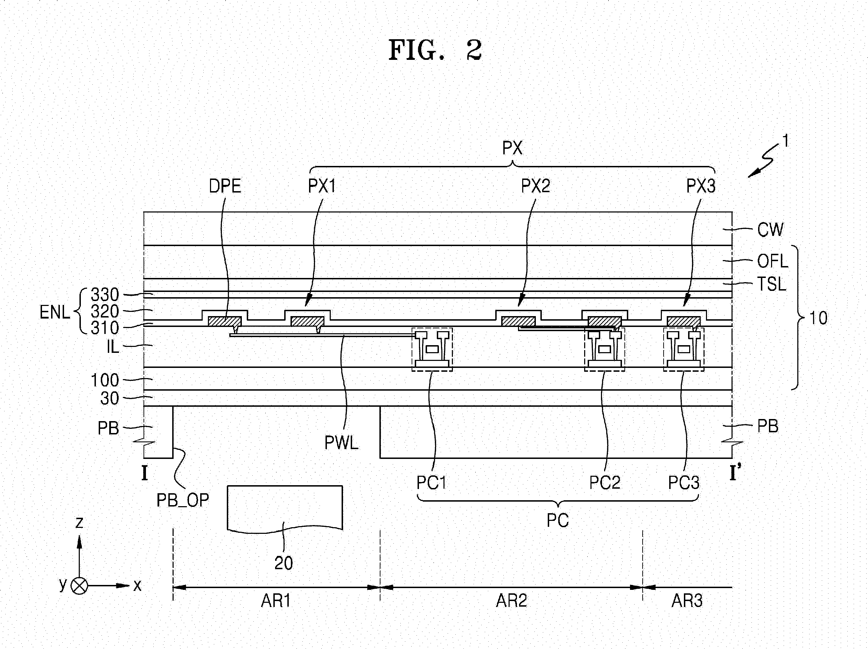

FIG. 2 is a cross-sectional view of an example of a portion of the display apparatus 1 in FIG. 1, taken along the line I-I' in FIG. 1.

Referring to FIG. 2, the display apparatus 1 may include a display panel 10, a panel-protecting member PB, a component 20, and a cover window CW. The display panel 10 may include a substrate 100, an insulating layer IL, a pixel circuit PC, a display element DPE, an encapsulation layer ENL, a touch sensor layer TSL, and an optical functional layer OFL.

The display apparatus 1 may include the first area AR1, the second areas AR2, and the third area AR3. In other words, the first area AR1, the second area AR2, and the third area AR3 may be defined in the substrate 100 and a multi-layer on the substrate 100. As an example, the first area AR1, the second area AR2, and the third area AR3 may be defined in the substrate 100. That is, the substrate 100 may include the first area AR1, the second area AR2, and the third area AR3. Hereinafter, the case where the substrate 100 includes the first area AR1, the second area AR2, and the third area AR3 is mainly described in more detail.

The substrate 100 may include an insulating material such as glass, quartz, a polymer resin or the like. The substrate 100 may be a rigid substrate or a flexible substrate that is bendable, foldable, and rollable.

The insulating layer IL and the pixel circuit PC may be located on the substrate 100. The insulating layer IL may insulate elements of the display panel 10. The insulating layer IL may include at least one of an organic material or an inorganic material. The pixel circuit PC may be electrically connected to the display element DPE to drive the display element DPE. The pixel circuit PC may be inserted into the insulating layer IL. According to some embodiments, the pixel circuit PC may include a first pixel circuit PC1, a second pixel circuit PC2, and a third pixel circuit PC3. The first pixel circuit PC1 and the second pixel circuit PC2 may be arranged in the second area AR2. The third pixel circuit PC3 may be arranged in the third area AR3. According to some embodiments, the pixel circuit PC may not be arranged in the first area AR1. Accordingly, a transmittance (e.g., a light transmittance) of the display panel 10 in the first area AR1 may be relatively greater than a transmittance of the display panel 10 in the third area AR3.

The display element DPE may be located on the insulating layer IL. According to some embodiments, the display element DPE may be an organic light-emitting diode including an organic emission layer. Alternatively, the display element DPE may be a light-emitting diode LED. The size of the light-emitting diode LED may be microscales or nanoscales. As an example, the light-emitting diode may be a micro light-emitting diode. Alternatively, the light-emitting diode may be a nano-rod light-emitting diode. The nano-rod light-emitting diode may include gallium nitride (GaN). According to some embodiments, a color-converting layer may be located on the nano-rod light-emitting diode. The color-converting layer may include quantum dots. Alternatively, the display element DPE may be a quantum-dot light-emitting diode including a quantum-dot emission layer. Alternatively, the display element DPE may be an inorganic light-emitting diode including an inorganic semiconductor. Hereinafter, the case where the display element DPE is an organic light-emitting diode is mainly described in more detail.

The display panel 10 may include a plurality of display elements DPE. The plurality of display elements DPE may be arranged in the first area AR1, the second area AR2, and the third area AR3. According to some embodiments, the display element DPE may implement the pixel PX by emitting light. As an example, the display elements DPE arranged in the first area AR1 may implement the first pixels PX1 by emitting light. The display elements DPE arranged in the second area AR2 may implement the second pixels PX2 by emitting light. The display elements DPE arranged in the third area AR3 may implement the third pixels PX3 by emitting light. Accordingly, the display apparatus 1 may be configured to display images in the first area AR1, the second area AR2, and the third area AR3.

According to some embodiments, the plurality of display elements DPE may be electrically connected to one first pixel circuit PC1. Accordingly, the plurality of display elements DPE may be configured to emit light using a small number of first pixel circuits PC1, and the number of first pixel circuits PC1 may be relatively reduced.

The first pixel circuit PC1 and the display element DPE arranged in the first area AR1 may be electrically connected to each other through a circuit connection line PWL. The circuit connection line PWL may extend from the second area AR2 to the first area AR1. Accordingly, the circuit connection line PWL may overlap the first area AR1 and the second area AR2 (e.g., in a plan view).

The circuit connection line PWL may include a transparent conductive material. As an example, the circuit connection line PWL may include a transparent conductive oxide (TCO). The circuit connection line PWL may include a conductive oxide such as indium tin oxide (ITO), indium zinc oxide (IZO), zinc oxide (ZnO), indium oxide (In₂O₃), indium gallium oxide (IGO), or aluminum zinc oxide (AZO).

The plurality of display elements DPE may be electrically connected to one second pixel circuit PC2. Accordingly, the plurality of display elements DPE may be configured to emit light using a small number of second pixel circuits PC2, and the number of second pixel circuits PC2 may be relatively reduced.

The encapsulation layer ENL may cover the display element DPE. According to some embodiments, the encapsulation layer ENL may include at least one inorganic encapsulation layer and at least one organic encapsulation layer. The at least one inorganic encapsulation layer may include at least one inorganic material among aluminum oxide (Al₂O₃), titanium oxide (TiO₂), tantalum oxide (Ta₂O₅), zinc oxide (ZnOₓ), silicon oxide (SiO₂), silicon nitride (SiNₓ), and silicon oxynitride (SiON). The at least one organic encapsulation layer may include a polymer-based material. The polymer-based material may include an acryl-based resin, an epoxy-based resin, polyimide, and polyethylene. According to some embodiments, the at least one organic encapsulation layer may include acrylate.

According to some embodiments, the encapsulation layer ENL may include a first inorganic encapsulation layer 310, an organic encapsulation layer 320, and a second inorganic encapsulation layer 330 that are sequentially stacked. The first inorganic encapsulation layer 310 and the second inorganic encapsulation layer 330 may be configured to prevent or reduce exposure of the organic encapsulation layer 320 and/or the display element DPE to foreign substances such as moisture or other contam inants.

According to some embodiments, the encapsulation layer ENL may have a structure in which an inner space between the substrate 100 and the upper substrate is encapsulated, wherein the substrate 100 and an upper substrate, which is a transparent member, are coupled to each other using a sealing member. In this case, a moisture absorbent or a filler may be located in the inner space. The sealing member may be a sealant. According to some embodiments, the sealing member may include a material cured by a laser beam. As an example, the sealing member may include frit. For example, the sealing member may include an organic sealant such as a urethane-based resin, an epoxy-based resin, an acrylic resin, or silicone which is an inorganic sealant. As a urethane-based resin, for example, urethane acrylate or the like may be used. As acrylic resin, for example, butyl acrylate, ethylhexyl acrylate, or the like may be used. The sealing member may include a material cured by heat.

The touch sensor layer TSL may obtain coordinate information corresponding to an external input, for example, a touch event. The touch sensor layer TSL may include a touch electrode and touch lines connected to the touch electrode. The touch sensor layer TSL may sense an external input by using a self-capacitance method or a mutual capacitance method.

The touch sensor layer TSL may be located on the encapsulation layer ENL. According to some embodiments, the touch sensor layer TSL may be directly located on the encapsulation layer ENL. In this case, an adhesive layer such as an optical clear adhesive may not be located between the touch sensor layer TSL and the encapsulation layer ENL. According to some embodiments, the touch sensor layer TSL may be separately formed on a touch substrate, and then, coupled to the encapsulation layer ENL through an adhesive layer such as an optical clear adhesive.

The optical functional layer OFL may include an anti-reflection layer. The anti-reflection layer may reduce reflectivity of light (external light) incident toward the display apparatus 1 from the outside. According to some embodiments, the optical functional layer OFL may be a polarizing film. According to some embodiments, the optical functional layer OFL may be a filter plate including a black matrix and color filters.

A cover window CW may be located on the display panel 10. The cover window CW may be configured to protect the display panel 10. The cover window CW may include at least one of glass, sapphire, or plastic. The cover window CW may be, for example, ultra-thin glass (UTG^{™}) or colorless polyimide (CPI).

The panel-protecting member PB may be located under the substrate 100. The panel-protecting member PB may support and protect the substrate 100. According to some embodiments, the panel-protecting member PB may have an opening PB_OP overlapping the first area AR1. According to some embodiments, the opening PB_OP of the panel-protecting member PB may overlap the first area AR1 and the second area AR2. According to some embodiments, the panel-protecting member PB may include polyethylene terephthalate or polyimide.

The component 20 may be located below the display panel 10. According to some embodiments, the component 20 may be arranged opposite the cover window CW with the display panel 10 therebetween. According to some embodiments, the component 20 may overlap the first area AR1. According to some embodiments, the component 20 may overlap the first area AR1 and the second area AR2.

The component 20 is a camera that uses an infrared ray or a visible ray and the like and may include an imaging element. Alternatively, the component 20 may be a solar cell, a flash, an illuminance sensor, a proximity sensor, or an iris sensor. Alternatively, the component 20 may have a function of receiving sound. To reduce the limitation of the function of the component 20, the first pixel circuit PC1 driving the display element DPE located in the first area AR1 is not located in the first area AR1 but is located in the second area AR2. Accordingly, a transmittance of the display panel 10 in the first area AR1 may be greater than a transmittance of the display panel 10 in the second area AR2.

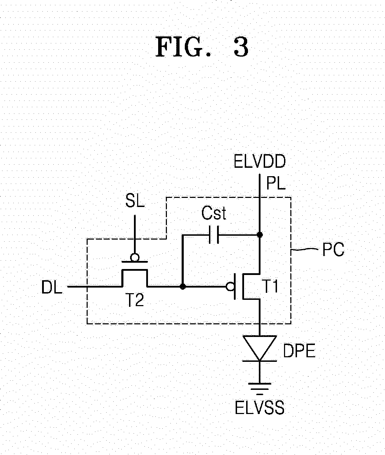

FIG. 3 is an equivalent circuit diagram of a pixel circuit electrically connected to a display element according to some embodiments.

Referring to FIG. 3, the pixel circuit PC may include a driving transistor T1, a scan transistor T2, and a storage capacitor Cst. According to some embodiments, the driving transistor T1 and the scan transistor T2 may be thin-film transistors.

The switching transistor T2 is electrically connected to a scan line SL and a data line DL, and configured to transfer a data voltage to the driving transistor T1 according to a scan signal input from the scan line SL, the data voltage being input from the data line DL. The storage capacitor Cst may be electrically connected to the scan transistor T2 and a driving voltage line PL and configured to store a voltage corresponding to a difference between a voltage transferred from the scan transistor T2 and a driving voltage ELVDD supplied to the driving voltage line PL.

The driving transistor T1 may be electrically connected to the driving voltage line PL and the storage capacitor Cst and configured to control a driving current according to the voltage stored in the storage capacitor Cst, the driving current flowing from the driving voltage line PL to the display element DPE. The display element DPE may be configured to emit light having a preset brightness based on the driving current. An opposite electrode of the display element DPE may receive a common voltage ELVSS.

Although it is shown in FIG. 3 that the pixel circuit PC includes two transistors and one storage capacitor, the pixel circuit PC may include three or more transistors. According to some embodiments, the pixel circuit PC may include additional components or fewer components without departing from the scope of embodiments according to the present disclosure.

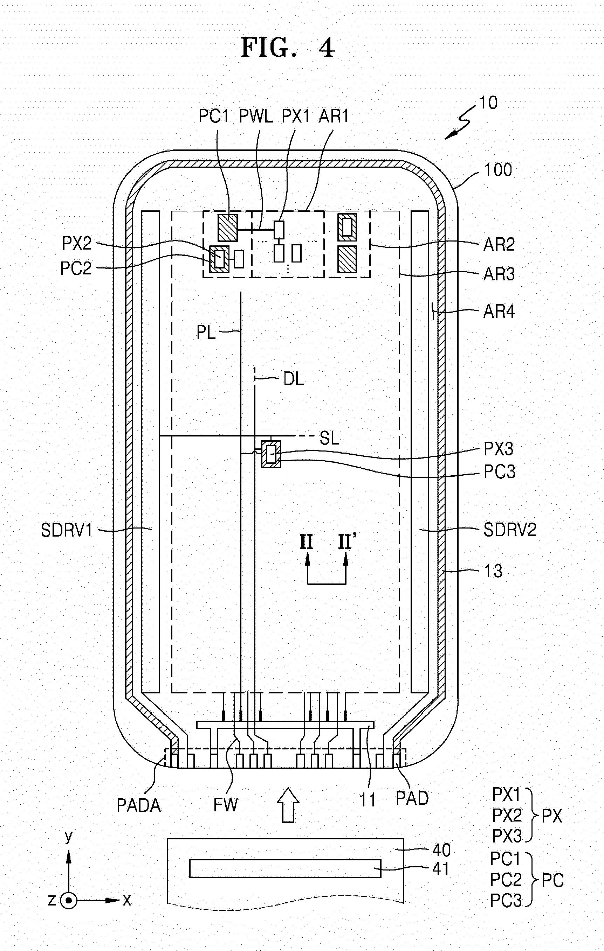

FIG. 4 is a schematic plan view of the display panel 10 according to some embodiments.

Referring to FIG. 4, the display panel 10 may include the substrate 100, the pixel circuit PC, and the pixel PX. According to some embodiments, the substrate 100 may include the first area AR1, the second area AR2, the third area AR3, and the fourth area AR4. The second area AR2 may be arranged on one side of the first area AR1. The third area AR3 may surround at least a portion of the first area AR1 and the second area AR2. The fourth area AR4 may surround at least a portion of the third area AR3.

The pixel circuit PC may include the first pixel circuit PC1, the second pixel circuit PC2, and the third pixel circuit PC3. According to some embodiments, the first pixel circuit PC1 and the second pixel circuit PC2 may be arranged in the second area AR2. The third pixel circuit PC3 may be arranged in the third area AR3. According to some embodiments, the pixel circuit PC may not be arranged in the first area AR1.

The pixel PX may be implemented by a display element such as an organic light-emitting diode. The pixels PX may include the first pixel PX1, the second pixel PX2, and the third pixel PX3. The first pixel PX1 may be arranged in the first area AR1. The first pixel PX1 may be electrically connected to the first pixel circuit PC1.

According to some embodiments, the first pixel PX1 may be electrically connected to the first pixel circuit PC1 through the pixel connection line PWL. According to some embodiments, one of the plurality of first pixels PX1 may be electrically connected to another of the plurality of first pixels PX1. In this case, one of the plurality of first pixels PX1 and the other of the plurality of first pixels PX1 may be connected to one first pixel circuit PC1 and configured to equally emit light.

The second pixel PX2 may be arranged in the second area AR2. The second pixel PX2 may be electrically connected to the second pixel circuit PC2. The second pixel PX2 may overlap the second pixel circuit PC2. According to some embodiments, one of the plurality of second pixels PX2 may be electrically connected to another of the plurality of second pixels PX2. In this case, one of the plurality of second pixels PX2 and the other of the plurality of second pixels PX2 may be connected to one second pixel circuit PC2 and configured to equally emit light.

The third pixel PX3 may be arranged in the third area AR3. The third pixel PX3 may be electrically connected to the third pixel circuit PC3. The third pixel PX3 may overlap the third pixel circuit PC3.

The pixel PX may be provided in plurality, and the plurality of pixels PX may be configured to display images by emitting light. According to some embodiments, the first pixel PX1, the second pixel PX2, and the third pixel PX3 may each be provided in plurality. The plurality of first pixels PX1, the plurality of second pixels PX2, and the plurality of third pixels PX3 may be configured to display one image, or display independent images, respectively.

According to some embodiments, the resolution of the display panel 10 in the first area AR1 and/or the second area AR2 may be equal to or less than the resolution of the display panel 10 in the third area AR3. As an example, the resolution of the display panel 10 in the first area AR1 and/or the second area AR2 may be about 1/2, 3/8, 1/3, 1/4, 2/9, 1/8, 1/9, or 1/16 of the resolution of the display panel 10 in the third area AR3.

The fourth area AR4 may be a non-display area in which the pixels PX are not arranged. A first scan driving circuit SDRV1, a second scan driving circuit SDRV2, a pad PAD, a driving voltage line 11, and a common voltage supply line 13 may be arranged in the fourth area AR4.

One of the first scan driving circuit SDRV1 and the second scan driving circuit SDRV2 may be configured to apply scan signals to the pixel circuit PC through the scan line SL. According to some embodiments, the first scan driving circuit SDRV1 and the second scan driving circuit SDRV2 may be arranged to be opposite to each other with the third area AR3 therebetween. According to some embodiments, one of the plurality of pixels PX may be configured to receive scan signals from the first scan driving circuit SDRV1, and another of the plurality of pixels PX may be configured to receive scan signals from the second scan driving circuit SDRV2.

The pad PAD may be arranged in a pad area PADA, which is one side of the fourth area AR4. The pad PAD may be exposed by not being covered by an insulating layer and connected to a display circuit board 40. A display driver 41 may be arranged on the display circuit board 40.

The display driver 41 may be configured to generate signals to be transferred to the first scan driving circuit SDRV1 and the second scan driving circuit SDRV2. The display driver 41 may be configured to generate data signals (or data voltages), and the generated data signals may be transferred to the pixel circuit PC through a fan-out wiring FW and a data line DL connected to the fan-out wiring FW.

The display driver 41 may be configured to supply the driving voltage ELVDD (see FIG. 3) to the driving voltage line 11 and supply the common voltage ELVSS (see FIG. 3) to the common voltage supply line 13. The driving voltage ELVDD may be supplied to the pixel circuit PC through the driving voltage line PL connected to the driving voltage line 11, and the common voltage ELVSS may be supplied to the opposite electrode of the display element connected to the common voltage supply line 13.

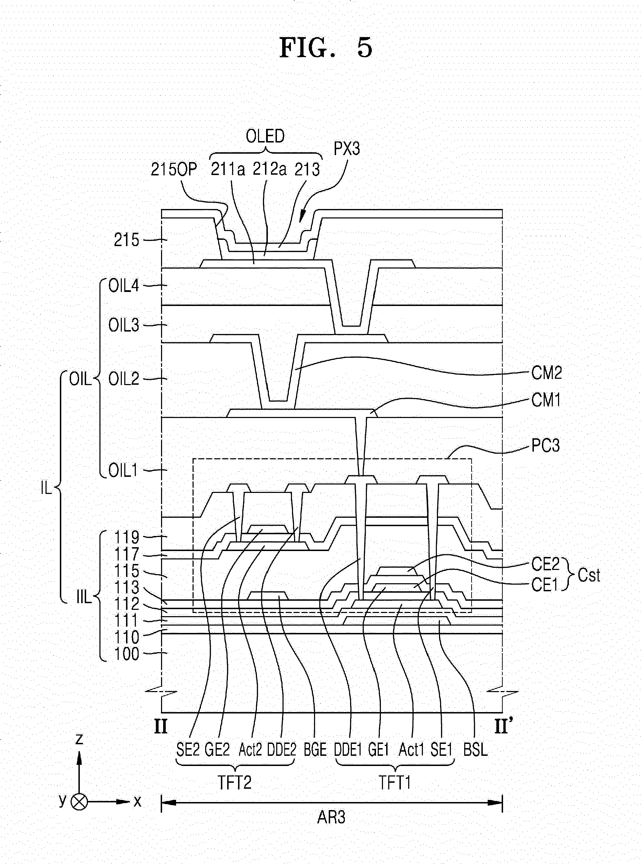

FIG. 5 is a cross-sectional view of an example of a portion of the display panel in FIG. 4, taken along the line II-II' in FIG. 4. For example, FIG. 5 is a cross-sectional view of an example of a portion of the third area AR3 in FIG. 4, taken along the line II-II' in FIG. 4.

Referring to FIG. 5, the display panel 10 may include the substrate 100, the insulating layer IL, the third pixel circuit PC3, the organic light-emitting diode OLED as the display element, and a pixel-defining layer 215.

The substrate 100 may include glass or polymer resin such as polyethersulfone, polyarylate, polyetherimide, polyethylene naphthalate, polyethylene terephthalate, polyphenylene sulfide, polyimide, polycarbonate, cellulose tri acetate, cellulose acetate propionate, and the like. According to some embodiments, the substrate 100 may have a multi-layered structure including a base layer and a barrier layer each including the above polymer resin. The substrate 100 including the polymer resin is flexible, rollable, or bendable.

The insulating layer IL may be located on the substrate 100. The insulating layer IL may include an inorganic insulating layer IIL and an organic insulating layer OIL. According to some embodiments, the inorganic insulating layer IIL may include a barrier layer 110, a buffer layer 111, a first gate insulating layer 112, a second gate insulating layer 113, a first inorganic insulating layer 115, a second inorganic insulating layer 117, and an interlayer insulating layer 119.

The third pixel circuit PC3 may be arranged in the third area AR3. The third pixel circuit PC3 may include a first transistor TFT1, a second transistor TFT2, and a storage capacitor Cst. The first transistor TFT1 may include a first semiconductor layer Act1, a first gate electrode GE1, a first source electrode SE1, and a first drain electrode DDE1. The second transistor TFT2 may include a second semiconductor layer Act2, a second gate electrode GE2, a second source electrode SE2, and a second drain electrode DDE2. The storage capacitor Cst may include a lower electrode CE1 and an upper electrode CE2.

The barrier layer 110 may be located on the substrate 100. The barrier layer 110 may be configured to prevent or reduce instances of impurities or contaminants from below the substrate 100, penetrating the first semiconductor layer Act1, and the second semiconductor layer Act2. The barrier layer 110 may include an inorganic material, an organic material, or an organic/inorganic composite material, and include a single layer or a multi-layer including an inorganic material and an organic material, the inorganic material including oxide or nitride.

The buffer layer 111 may be located on the barrier layer 110. The buffer layer 111 may include an inorganic insulating material such as silicon nitride (SiNₓ), silicon oxynitride (SiON), and silicon oxide (SiO₂), and include a single layer or a multi-layer including the inorganic insulating materials.

The first semiconductor layer Act1 may include a silicon semiconductor. The first semiconductor layer Act1 may include polycrystalline silicon. Alternatively, the first semiconductor layer Act1 may include amorphous silicon. According to some embodiments, the first semiconductor layer Act1 may include an oxide semiconductor, an organic semiconductor or the like. The first semiconductor layer Act1 may include a channel region, a drain region, and a source region, the drain region and the source region being on two opposite sides of the channel region. The first gate electrode GE1 may overlap the channel region.

The first gate electrode GE1 may overlap the first semiconductor layer Act1. The first gate electrode GE1 may include a low-resistance metal material. The first gate electrode GE1 may include a conductive material including molybdenum (Mo), aluminum (Al), copper (Cu), and titanium (Ti) and have a single-layered structure or a multi-layered structure including the above materials.

The first gate insulating layer 112 may be located between the first semiconductor layer Act1 and the first gate electrode GE1. Accordingly, the first semiconductor layer Act1 may be insulated from the first gate electrode GE1. The first gate insulating layer 112 may include an inorganic insulating material such as silicon oxide (SiO₂), silicon nitride (SiNₓ), silicon oxynitride (SiON), aluminum oxide (Al₂O₃), titanium oxide (TiO₂), tantalum oxide (Ta₂O₅), hafnium oxide (HfO₂), and/or zinc oxide (ZnO).

The second gate insulating layer 113 may cover the first gate electrode GE1. The second gate insulating layer 113 may be located on the first gate electrode GE1. Similarly to the first gate insulating layer 112, the second gate insulating layer 113 may include an inorganic insulating material including silicon oxide (SiO₂), silicon nitride (SiNₓ), silicon oxynitride (SiON), aluminum oxide (Al₂O₃), titanium oxide (TiO₂), tantalum oxide (Ta₂O₅), hafnium oxide (HfO₂), and/or zinc oxide (ZnO).

The upper electrode CE2 may be located on the second gate insulating layer 113. The upper gate electrode CE2 may overlap the first gate electrode GE1 therebelow. In this case, the upper electrode CE2 may overlap the first gate electrode GE1 with the second gate insulating layer 113 therebetween to constitute the storage capacitor Cst. That is, the first gate electrode GE1 of the first transistor TFT1 may serve as the lower electrode CE1 of the storage capacitor Cst.

As described above, the storage capacitor Cst may overlap the first transistor TFT1. According to some embodiments, the storage capacitor Cst may be formed not to overlap the first transistor TFT1.

The upper electrode CE2 may include aluminum (Al), platinum (Pt), palladium (Pd), silver (Ag), magnesium (Mg), gold (Au), nickel (Ni), neodymium (Nd), iridium (Ir), chrome (Cr), calcium (Ca), molybdenum (Mo), titanium (Ti), tungsten (W), and/or copper (Cu), and include a single layer or a multi-layer including one or more of the above materials.

The first inorganic insulating layer 115 may cover the upper electrode CE2. According to some embodiments, the first inorganic insulating layer 115 may cover the first gate electrode GE1. The first inorganic insulating layer 115 may include silicon oxide (SiO₂), silicon nitride (SiNₓ), silicon oxynitride (SiON), aluminum oxide (Al₂O₃), titanium oxide (TiO₂), tantalum oxide (Ta₂O₅), hafnium oxide (HfO₂), or zinc oxide (ZnO). The first inorganic insulating layer 115 may include a single layer or a multi-layer including the inorganic insulating material.

The second semiconductor layer Act2 may be located on the first inorganic insulating layer 115. According to some embodiments, the second semiconductor layer Act2 may include a channel region, a drain region, and a source region, the drain region and the source region being respectively on two opposite sides of the channel region. The second semiconductor layer Act2 may include an oxide semiconductor. As an example, the second semiconductor layer Act2 may include Zn-oxide-based material and include Zn-oxide, In-Zn oxide, and Ga-In-Zn oxide. Alternatively, the second semiconductor layer Act2 may include In-Ga-Zn-O (IGZO), In-Sn-Zn-O (ITZO), or In-Ga-Sn-Zn-O (IGTZO) semiconductor containing metal such as indium (In), gallium (Ga), and stannum (Sn) in ZnO.

The source region and the drain region of the second semiconductor layer Act2 may be formed by adjusting a carrier concentration of the oxide semiconductor and making the relevant regions conductive. For example, the source region and the drain region of the second semiconductor layer Act2 may be formed by increasing carrier concentration through plasma treatment that uses a hydrogen-based gas, a fluorine-based gas, or a combination of these performed on the oxide semiconductor.

The second inorganic insulating layer 117 may cover the second semiconductor layer Act2. The second inorganic insulating layer 117 may be located between the second semiconductor layer Act2 and the second gate electrode GE2. According to some embodiments, the second inorganic insulating layer 117 may be located on the substrate 100 entirely. According to some embodiments, the second inorganic insulating layer 117 may be patterned along the shape of the second gate electrode GE2. The second inorganic insulating layer 117 may include silicon oxide (SiO₂), silicon nitride (SiNₓ), silicon oxynitride (SiON), aluminum oxide (Al₂O₃), titanium oxide (TiO₂), tantalum oxide (Ta₂O₅), hafnium oxide (HfO₂), or zinc oxide (ZnO). The second inorganic insulating layer 117 may include a single layer or a multi-layer including the inorganic insulating material.

The second gate electrode GE2 may be located on the second inorganic insulating layer 117. The second gate electrode GE2 may overlap the second semiconductor layer Act2. The second gate electrode GE2 may overlap the channel region of the second semiconductor layer Act2. The second gate electrode GE2 may include a conductive material including molybdenum (Mo), aluminum (Al), copper (Cu), and titanium (Ti) and have a single-layered structure or a multi-layered structure including the above materials.

The interlayer insulating layer 119 may cover the second capacitor electrode CE2. The interlayer insulating layer 119 may include silicon oxide (SiO₂), silicon nitride (SiNₓ), silicon oxynitride (SiON), aluminum oxide (Al₂O₃), titanium oxide (TiO₂), tantalum oxide (Ta₂O₅), hafnium oxide (HfO₂), or zinc oxide (ZnO₂). The interlayer insulating layer 119 may include a single layer or a multi-layer including the inorganic insulating material.

The first source electrode SE1 and the first drain electrode DDE1 may be located on the interlayer insulating layer 119. The first source electrode SE1 and the first drain electrode DDE1 may be connected to the first semiconductor layer Act1. The first source electrode SE1 and the first drain electrode DDE1 may be connected to the first semiconductor layer Act1 through contact holes of the insulating layers.

The second source electrode SE2 and the second drain electrode DDE2 may be located on the interlayer insulating layer 119. The second source electrode SE2 and the second drain electrode DDE2 may be electrically connected to the second semiconductor layer Act2. The second source electrode SE2 and the second drain electrode DDE2 may be electrically connected to the second semiconductor layer Act2 through contact holes of the insulating layers.

The first source electrode SE1, the first drain electrode DDE1, the second source electrode SE2, and the second drain electrode DDE2 may each include a material having high conductivity. The first source electrode SE1, the first drain electrode DDE1, the second source electrode SE2, and the second drain electrode DDE2 may each include a conductive material including molybdenum (Mo), aluminum (Al), copper (Cu), titanium (Ti), and the like, and include a multi-layer or a single layer including the above materials. According to some embodiments, the first source electrode SE1, the first drain electrode DDE1, the second source electrode SE2, and the second drain electrode DDE2 may each have a multi-layered structure of Ti/Al/Ti.

Because the first transistor TFT1 including the first semiconductor layer Act1 including a silicon semiconductor has a high reliability, the first transistor TFT1 may be employed as a driving transistor to implement a display panel 10 of high-quality.

Because the oxide semiconductor has a high carrier mobility and a low leakage current, a voltage drop may not be large even though a driving time is long. That is, because a color change of an image according to a voltage drop is not large even while the display apparatus is driven in low frequencies, the display apparatus may be driven in low frequencies. Because the oxide semiconductor has an advantage of a small leakage current, at least one of the transistors besides the driving transistor may employ the oxide semiconductor, and thus, a leakage current may be prevented or reduced, and simultaneously (or concurrently), power consumption may be relatively reduced. As an example, the second transistor TFT2 may be employed as a switching transistor.

A bottom gate electrode BGE may be located below the second semiconductor layer Act2. According to some embodiments, the bottom gate electrode BGE may be located between the second gate insulating layer 113 and the first inorganic insulating layer 115. According to some embodiments, the bottom gate electrode BGE may be configured to receive a gate signal. In this case, the second transistor TFT2 may have a double gate electrode structure in which gate electrodes are located over and below the second semiconductor layer Act2.

According to some embodiments, a bottom shielding layer BSL may be located between the substrate 100 and the third pixel circuit PC3 that overlaps the third area AR3. According to some embodiments, the bottom shielding layer BSL may overlap the first transistor TFT1. A constant voltage may be applied to the bottom shielding layer BSL. Because the bottom shielding layer BSL is located below the first transistor TFT1, the first transistor TFT1 is less influenced by neighboring interference signals, and thus, the reliability of the first transistor TFT1 may be improved.

The bottom shielding layer BSL may include a transparent conductive material. As an example, the bottom shielding layer BSL may include a transparent conductive oxide (TCO). The bottom shielding layer BSL may include a conductive oxide such as indium tin oxide (ITO), indium zinc oxide (IZO), zinc oxide (ZnO), indium oxide (In₂O₃), indium gallium oxide (IGO), or aluminum zinc oxide (AZO).

The organic insulating layer OIL may be located on the inorganic insulating layer IIL. According to some embodiments, the organic insulating layer OIL may be located on the substrate 100. The organic insulating layer OIL may include a first organic insulating layer OIL1, a second organic insulating layer OIL2, a third organic insulating layer OIL3, and a fourth organic insulating layer OIL4.

The first organic insulating layer OIL1 may cover the first source electrode SE1, the first drain electrode DDE1, the second source electrode SE2, and the second drain electrode DDE2. The first organic insulating layer OL1 may include an organic material. As an example, the first organic insulating layer OIL1 may include an organic insulating material including a general-purpose polymer such as polymethylmethacrylate (PMMA) or polystyrene (PS), polymer derivatives having a phenol-based group, an acryl-based polymer, an imide-based polymer, an aryl ether-based polymer, an amide-based polymer, a fluorine-based polymer, a p-xylene-based polymer, a vinyl alcohol-based polymer, or a blend thereof.

A first connection electrode CM1 may be located on the first organic insulating layer OIL1. The first connection electrode CM1 may be connected to the first drain electrode DDE1 or the first source electrode SE1 through a contact hole of the first organic insulating layer OIL1. The first connection electrode CM1 may include a material having a high conductivity. The first connection electrode CM1 may include a conductive material including molybdenum (Mo), aluminum (Al), copper (Cu), and titanium (Ti) and have a single-layered structure or a multi-layered structure including the above materials. According to some embodiments, the first connection electrode CM1 may have a multi-layered structure of Ti/Al/Ti.

The second organic insulating layer OIL2 may cover the first connection electrode CM1. The second organic insulating layer OIL2 may include an organic material. As an example, the second organic insulating layer OIL2 may include an organic insulating material including a general-purpose polymer such as polymethylmethacrylate (PMMA) or polystyrene (PS), polymer derivatives having a phenol-based group, an acryl-based polymer, an imide-based polymer, an aryl ether-based polymer, an amide-based polymer, a fluorine-based polymer, a p-xylene-based polymer, a vinyl alcohol-based polymer, or a blend thereof.

A second connection electrode CM2 may be located on the second organic insulating layer OIL2. The second connection electrode CM2 may be connected to the first connection electrode CM1 through a contact hole of the second organic insulating layer OIL2. The second connection electrode CM2 may include a transparent conductive material. As an example, the second connection electrode CM2 may include a transparent conductive oxide (TCO). The second connection electrode CM2 may include a conductive oxide such as indium tin oxide (ITO), indium zinc oxide (IZO), zinc oxide (ZnO), indium oxide (In₂O₃), indium gallium oxide (IGO), or aluminum zinc oxide (AZO).

The third organic insulating layer OIL3 may cover the second connection electrode CM2. The third organic insulating layer OIL3 may include an organic material. As an example, the third organic insulating layer OIL3 may include an organic insulating material including a general-purpose polymer such as polymethylmethacrylate (PMMA) or polystyrene (PS), polymer derivatives having a phenol-based group, an acryl-based polymer, an imide-based polymer, an aryl ether-based polymer, an amide-based polymer, a fluorine-based polymer, a p-xylene-based polymer, a vinyl alcohol-based polymer, or a blend thereof.

The fourth organic insulating layer OIL4 may be located on the third organic insulating layer OIL3. The fourth organic insulating layer OIL4 may include an organic material. As an example, the fourth organic insulating layer OIL4 may include an organic insulating material including a general-purpose polymer such as polymethylmethacrylate (PMMA) or polystyrene (PS), polymer derivatives having a phenol-based group, an acryl-based polymer, an imide-based polymer, an aryl ether-based polymer, an amide-based polymer, a fluorine-based polymer, a p-xylene-based polymer, a vinyl alcohol-based polymer, or a blend thereof.

According to some embodiments, a conductive layer may be located between the third organic insulating layer OIL3 and the fourth organic insulating layer OIL4. The conductive layer may include a transparent conductive material. As an example, the conductive layer may include a transparent conductive oxide (TCO). The conductive layer may include a conductive oxide such as indium tin oxide (ITO), indium zinc oxide (IZO), zinc oxide (ZnO), indium oxide (In₂O₃), indium gallium oxide (IGO), or aluminum zinc oxide (AZO).

Unlike the illustration in FIG. 5, the second connection electrode CM2 may be omitted. Accordingly, the second organic insulating layer OIL2, the third organic insulating layer OIL3, and the fourth organic insulating layer OIL4 may be provided as one organic insulating layer. That is, the third organic insulating layer OIL3 and the fourth organic insulating layer OIL4 may be omitted. A pixel electrode 211a described below may be electrically connected to the second connection electrode CM2 through a contact hole provided in the second organic insulating layer OIL2. According to some embodiments, an inorganic insulating layer may be additionally located between the first organic insulating layer OIL1 and the interlayer insulating layer 119, and accordingly, the thickness of the first organic insulating layer OIL1 may be thin. The transmittance of the display panel 10 may be improved by removing a portion of the organic insulating layer OIL having a relatively large amount of light absorption.

The first organic insulating layer OIL1 may cover the first source electrode SE1, the first drain electrode DDE1, the second source electrode SE2, and the second drain electrode DDE2.

The organic light-emitting diode OLED as the display element may be located on the organic insulating layer OIL. The organic light-emitting diode OLED may be electrically connected to the pixel circuit. In the third area AR3, the organic light-emitting diode OLED may be electrically connected to the third pixel circuit PC3 to implement the third pixel PX3. According to some embodiments, the organic light-emitting diode OLED may overlap the third pixel circuit PC3. The organic light-emitting diode OLED may include the pixel electrode 211a, an intermediate layer 212a, and an opposite electrode 213.

The pixel electrode 211a may be located on the organic insulating layer OIL. The pixel electrode 211a may be electrically connected to the second connection electrode CM2 through contact holes provided in the third organic insulating layer OIL3 and the fourth organic insulating layer OIL4. The pixel electrode 211a may include a conductive oxide such as indium tin oxide (ITO), indium zinc oxide (IZO), zinc oxide (ZnO), indium oxide (In₂O₃), indium gallium oxide (IGO), or aluminum zinc oxide (AZO). According to some embodiments, the pixel electrode 211a may include a reflective layer including silver (Ag), magnesium (Mg), aluminum (Al), platinum (Pt), palladium (Pd), gold (Au), nickel (Ni), neodymium (Nd), iridium (Ir), chrome (Cr), or a compound thereof. According to some embodiments, the pixel electrode 211a may further include a layer on/under the reflective layer, the layer including ITO, IZO, ZnO, or In₂O₃.

The pixel-defining layer 215 may be located on the pixel electrode 211a, wherein the pixel-defining layer 215 includes an opening 215OP exposing the central portion of the pixel electrode 211a. The opening 215OP may define an emission area of light emitted from the organic light-emitting diode OLED. The pixel-defining layer 215 may include at least one organic insulating material from among polyimide, an acrylic resin, benzocyclobutene, a phenolic resin, and the like. The pixel-defining layer 215 may include an organic insulating material. Alternatively, the pixel-defining layer 215 may include an inorganic insulating material such as silicon nitride, silicon oxynitride, or silicon oxide. Alternatively, the pixel-defining layer 215 may include an organic insulating material and an inorganic insulating material.

According to some embodiments, the pixel-defining layer 215 may include a light-blocking material and be provided in black. The light-blocking material may include carbon black, carbon nanotubes, a resin or paste including black dye, metal particles, for example, nickel, aluminum, molybdenum, and an alloy thereof, metal oxide particles (e.g., chrome oxide) or metal nitride particles (e.g., chrome nitride). In the case where the pixel-defining layer 215 includes a light-blocking material, external light reflection by metal structures arranged below the pixel-defining layer 215 may be reduced.

The intermediate layer 212a may include a low-molecular weight material or a polymer material, and emit red, green, blue, or white light. In the case where the intermediate layer 212a includes a low molecular weight material, the intermediate layer 212a may have a structure in which a hole injection layer (HIL), a hole transport layer (HTL), an emission layer (EML), an electron transport layer (ETL), an electron injection layer (EIL), etc. are stacked in a single or composite configuration. The intermediate layer 220 may include various organic materials such as copper phthalocyanine (CuPc), N, N'-Di (naphthalene-1-yl)-N, N'-diphenyl-benzidine (NPB), and tris-8-hydroxyquinoline aluminum (Alq3). These layers may be formed by vacuum deposition.

In the case where the intermediate layer 212a includes a polymer material, the intermediate layer 212a may have a structure including an HTL and an EML. In this case, the HTL may include poly (3, 4-ethylenedioxythiophene) (PEDOT), and the EML may include a polymer material such as a polyphenylene vinylene (PPV)-based material and a polyfluorene-based material. The intermediate layer 212a may be formed by screen printing, inkjet printing, laser induced thermal imaging (LITI), or the like.

The opposite electrode 213 may be located on the intermediate layer 212a. The opposite electrode 213 may include a conductive material having a low work function. As an example, the opposite electrode 213 may include a (semi) transparent layer including silver (Ag), magnesium (Mg), aluminum (Al), platinum (Pt), palladium (Pd), gold (Au), nickel (Ni), neodymium (Nd), iridium (Ir), chrome (Cr), or an alloy thereof. Alternatively, the opposite electrode 213 may further include a layer on the (semi) transparent layer, the layer including ITO, IZO, ZnO, or In₂O₃.

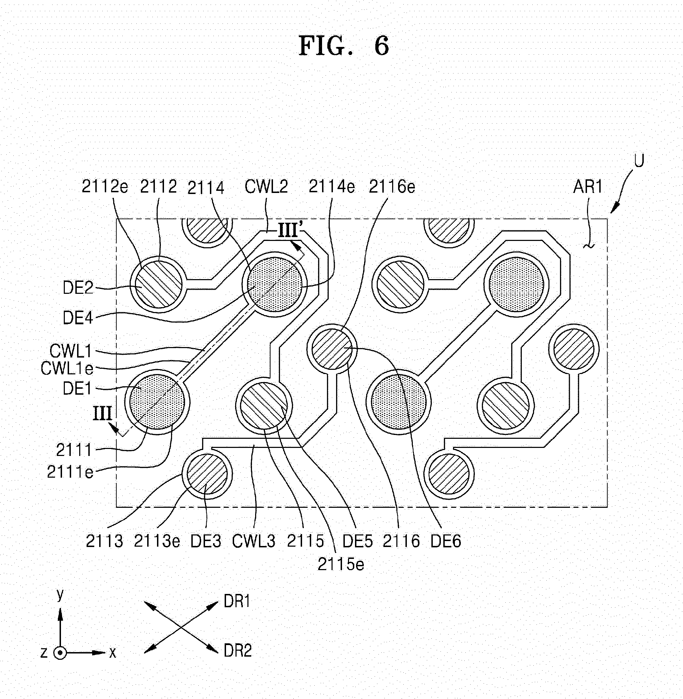

FIG. 6 is a schematic enlarged plan view of a portion of the display panel 10 according to some embodiments. For example, FIG. 6 is a schematic enlarged plan view of a portion of the first area AR1 of FIG. 4.

Referring to FIG. 6, first to sixth display elements DE1, DE2, DE3, DE4, DE5, and DE6, and first to third connection lines CWL1, CWL2, and CWL3 may be arranged in the first area AR1.

The first to sixth display elements DE1, DE2, DE3, DE4, DE5, and DE6 may be configured to implement the first pixel PX1 of FIG. 4. The first to third display elements DE1, DE2, and DE3 may be configured to emit light of different colors, and the fourth to sixth display elements DE4, DE5, and DE6 may be configured to emit light of different colors. As an example, the first and fourth display elements DE1 and DE4 may be configured to emit light of a first color (e.g., blue), the second and fifth display elements DE2 and DE5 may be configured to emit light of a second color (e.g., red), and the third and sixth display elements DE3 and DE6 may be configured to emit light of a third color (e.g., green). A first emission area of the first display element DE1 and a fourth emission area of the fourth display element DE4 may be configured to emit light of the first color, a second emission area of the second display element DE2 and a fifth emission area of the fifth display element DE5 may be configured to emit light of the second color, and a third emission area of the third display element DE3 and a sixth emission area of the sixth display element DE6 may be configured to emit light of the third color.

The first display element DE1 may include a first pixel electrode 2111, and the second display element DE2 may include a second pixel electrode 2112. The third display element DE3 may include a third pixel electrode 2113, and the fourth display element DE4 may include a fourth pixel electrode 2114. The fifth display element DE5 may include a fifth pixel electrode 2115, and the sixth display element DE6 may include a sixth pixel electrode 2116.

The first emission area of the first display element DE1 may be defined by an opening of the pixel-defining layer 215 (see FIG. 5) exposing the first pixel electrode 2111. The second emission area of the second display element DE2 may be defined by an opening of the pixel-defining layer 215 exposing the second pixel electrode 2112. The third emission area of the third display element DE3 may be defined by an opening of the pixel-defining layer 215 exposing the third pixel electrode 2113. The fourth emission area of the fourth display element DE4 may be defined by an opening of the pixel-defining layer 215 exposing the fourth pixel electrode 2114. The fifth emission area of the fifth display element DE5 may be defined by an opening of the pixel-defining layer 215 exposing the fifth pixel electrode 2115. The sixth emission area of the sixth display element DE6 may be defined by an opening of the pixel-defining layer 215 exposing the sixth pixel electrode 2116.

According to some embodiments, as shown in FIG. 6, the first display element DE1 and the fourth display element DE4 may be arranged in a first direction DR1. The second display element DE2 and the fifth display element DE5 may be sequentially arranged in a second direction DR2 crossing the first direction DR1. The third display element DE3 and the sixth display element DE6 may be arranged in the first direction DR1.

According to some embodiments, the first to sixth display elements DE1 to DE6 may be provided in plurality. In this case, a sum of the number of first display elements DE1 per unit area and the number of fourth display elements DE4 per unit area may be equal to a sum of the number of second display elements DE2 per unit area and the number of fifth display elements DE5 per unit area. A sum of the number of second display elements DE2 per unit area and the number of fifth display elements DE5 per unit area may be equal to a sum of the number of third display elements DE3 per unit area and the number of sixth display elements DE6 per unit area.

The first connection line CWL1 may connect the first pixel electrode 2111 of the first display element DE1 and the fourth pixel electrode 2114 of the fourth display element DE4 to each other. The second connection line CWL2 may connect the second pixel electrode 2112 of the second display element DE2 and the fifth pixel electrode 2115 of the fifth display element DE5 to each other. The third connection line CWL3 may connect the third pixel electrode 2113 of the third display element DE3 and the sixth pixel electrode 2116 of the sixth display element DE6 to each other.

According to some embodiments, one end of the first connection line CWL1 may be connected to the first pixel electrode 2111, and another end of the first connection line CWL1 may be connected to the fourth pixel electrode 2114. One end of the second connection line CWL2 may be connected to the second pixel electrode 2112, and another end of the second connection line CWL2 may be connected to the fifth pixel electrode 2115. One end of the third connection line CWL3 may be connected to the third pixel electrode 2113, and another end of the third connection line CWL3 may be connected to the sixth pixel electrode 2116.

According to some embodiments, the first connection line CWL1 may be in direct contact with the first display element DE1 and the fourth display element DE4. The second connection line CWL2 may be in direct contact with the second display element DE2 and the fifth display element DE5. The third connection line CWL3 may be in direct contact with the third display element DE3 and the sixth display element DE6. Further details according to some embodiments are described below.

According to some embodiments, the first connection line CWL1 may at least partially overlap the first pixel electrode 2111 of the first display element DE1 and the fourth pixel electrode 2114 of the fourth display element DE4.

According to some embodiments, an edge CWL1e of the first connection line CWL1 may surround an edge 2111e of the first pixel electrode 2111 and an edge 2114e of the fourth pixel electrode 2114. In other words, the edge 2111e of the first pixel electrode 2111 may be arranged inside the edge CWL1e of the first connection line CWL1. The edge 2114e of the fourth pixel electrode 2114 may be arranged inside the edge CWL1e of the first connection line CWL1. According to some embodiments, a portion of the edge CWL1e of the first connection line CWL1 may coincide with the edge 2111e of the first pixel electrode 2111 and the edge 2114e of the fourth pixel electrode 2114.

In the case where the first connection line CWL1 covers the lower surfaces of the first pixel electrode 2111 and the fourth pixel electrode 2114, the flatness of the first pixel electrode 2111 and the fourth pixel electrode 2114 may be improved.

According to some embodiments, the second connection line CWL2 may at least partially overlap the second pixel electrode 2112 of the second display element DE2 and the fifth pixel electrode 2115 of the fifth display element DE5.

According to some embodiments, an edge CWL2e of the second connection line CWL2 may surround an edge 2112e of the second pixel electrode 2112 and an edge 2115e of the fifth pixel electrode 2115. In other words, the edge 2112e of the second pixel electrode 2112 may be arranged inside the edge CWL2e of the second connection line CWL2. The edge 2115e of the fifth pixel electrode 2115 may be arranged inside the edge CWL2e of the second connection line CWL2. According to some embodiments, a portion of the edge CWL2e of the second connection line CWL2 may coincide with the edge 2112e of the second pixel electrode 2112 and the edge 2115e of the fifth pixel electrode 2115.

In the case where the second connection line CWL2 covers the lower surfaces of the second pixel electrode 2112 and the fifth pixel electrode 2115, the flatness of the second pixel electrode 2112 and the fifth pixel electrode 2115 may be improved.

According to some embodiments, the third connection line CWL3 may at least partially overlap the third pixel electrode 2113 of the third display element DE3 and the sixth pixel electrode 2116 of the sixth display element DE6.

According to some embodiments, an edge CWL3e of the third connection line CWL3 may surround an edge 2113e of the third pixel electrode 2113 and an edge 2116e of the sixth pixel electrode 2116. In other words, the edge 2113e of the third pixel electrode 2113 may be arranged inside the edge CWL3e of the third connection line CWL3. The edge 2116e of the sixth pixel electrode 2116 may be arranged inside the edge CWL3e of the third connection line CWL3. According to some embodiments, a portion of the edge CWL3e of the third connection line CWL3 may coincide with the edge 2113e of the third pixel electrode 2113 and the edge 2116e of the sixth pixel electrode 2116.

In the case where the third connection line CWL3 covers the lower surfaces of the third pixel electrode 2113 and the sixth pixel electrode 2116, the flatness of the third pixel electrode 2113 and the sixth pixel electrode 2116 may be improved.

According to some embodiments, the first connection line CWL1 may extend in the first direction DR1 in which the first pixel electrode 2111 and the fourth pixel electrode 2114 are arranged. The second connection line CWL2 may extend by bypassing the first connection line CWL1 to avoid an overlap with the first connection line CWL1. The third connection line CWL3 may extend by bypassing the first connection line CWL1 or the second connection line CWL2 to avoid an overlap with the first connection line CWL1 or the second connection line CWL2.

According to some embodiments, unlike FIG. 6, the second connection line CWL2 may extend in a second direction DR2 in which the second pixel electrode 2112 and the fifth pixel electrode 2115 are arranged. In this case, the first connection line CWL1 may extend by bypassing the second connection line CWL2 to avoid an overlap with the second connection line CWL2. The third connection line CWL3 may extend by bypassing the first connection line CWL1 or the second connection line CWL2 to avoid an overlap with the first connection line CWL1 or the second connection line CWL2.

The first to sixth display elements DE1, DE2, DE3, DE4, DE5, and DE6, and the first to third connection lines CWL1, CWL2, and CWL3 may constitute one unit U. The unit U may be provided in plurality, and the plurality of units U may be arranged in an x direction and a y direction.

According to some embodiments, the first to third connection lines CWL1, CWL2, and CWL3 may each include a transparent conductive oxide (TCO). The first to third connection lines CWL1, CWL2, and CWL3 may each include a conductive oxide such as indium tin oxide (ITO), indium zinc oxide (IZO), zinc oxide (ZnO), indium oxide (In₂O₃), indium gallium oxide (IGO), or aluminum zinc oxide (AZO). According to some embodiments, the first to third connection lines CWL1, CWL2, and CWL3 may each include poly indium tungsten oxide (poly-ITO). Because the first to third connection lines CWL1, CWL2, and CWL3 include a transparent conducive oxide, a transmittance of the first area AR1 may increase.

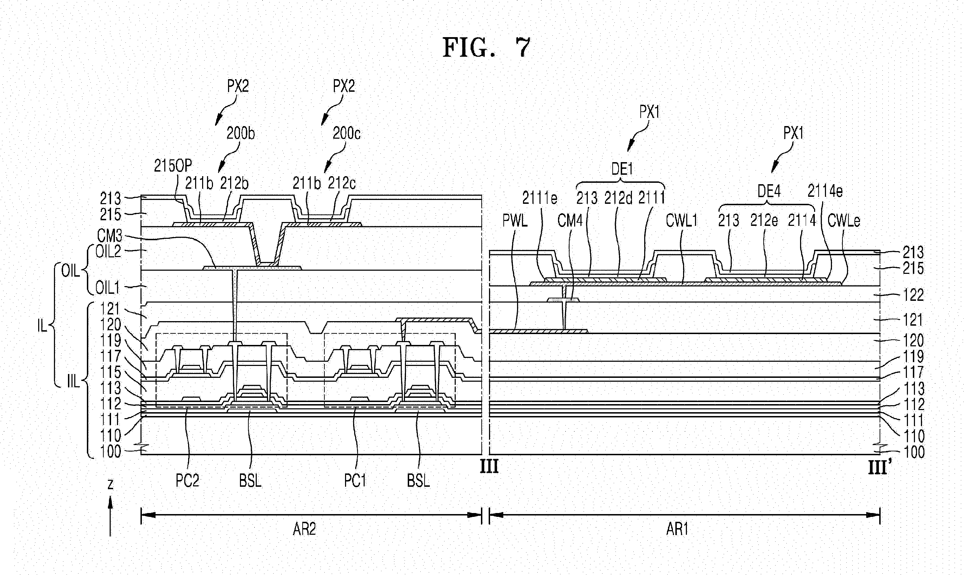

FIG. 7 is a cross-sectional view of an example of a portion of the display panel 10 in FIG. 6, taken along the line III-III' in FIG. 6. For example, FIG. 7 is a cross-sectional view of an example of a portion of the second area AR2 of FIG. 4, and a cross-sectional view of an example of a portion of the first area AR1 of FIG. 6, taken along the line III-III' of FIG. 6. In FIG. 7, the same reference numerals as those of FIG. 5 denote the same members, and thus, repeated descriptions thereof are omitted.

Referring to FIG. 7, the first pixels PX1 may be arranged in the first area AR1, and the first pixel circuit PC1, the second pixel circuit PC2, and the second pixels PX2 may be arranged in the second area AR2. The description of the third pixel circuit PC3 with reference to FIG. 5 is equally applicable to the first pixel circuit PC1 and the second pixel circuit PC2.

Referring to FIG. 7, a third inorganic insulating layer 120 and a fourth inorganic insulating layer 121 may be located on the first pixel circuit PC1 and the second pixel circuit PC2 in the second area AR2. The third inorganic insulating layer 120 and the fourth inorganic insulating layer 121 may extend to the first area AR1. A fifth inorganic insulating layer 122 may be located on the fourth inorganic insulating layer 121 in the first area AR1.

The first pixels PX1 may be implemented by the first display element DE1 and the fourth display element DE4. The first display element DE1 may include the first pixel electrode 2111, a first intermediate layer 212d, and the opposite electrode 213, and the fourth display element DE4 may include the fourth pixel electrode 2114, a second intermediate layer 212e, and the opposite electrode 213. The first intermediate layer 212d and the second intermediate layer 212e may include a polymer material or a low molecular weight material and be configured to emit red, green, blue, or white light. As an example, the first intermediate layer 212d and the second intermediate layer 212e may be configured to emit blue light.

The second pixels PX2 may be implemented by a seventh display element 200b and an eighth display element 200c arranged in the second area AR2. The seventh display element 200b may include a seventh pixel electrode 211b, a third intermediate layer 212b, and the opposite electrode 213, and the eighth display element 200c may include the seventh pixel electrode 211b, a fourth intermediate layer 212c, and the opposite electrode 213. The seventh display element 200b and the eighth display element 200c may share the seventh pixel electrode 211b. The third intermediate layer 212b and the fourth intermediate layer 212c may include a polymer material or a low molecular weight material and be configured to emit red, green, blue, or white light.

According to some embodiments, the circuit connection line PWL may overlap the first area AR1 and the second area AR2. The first display element DE1 and the fourth display element DE4 may be electrically connected to the first pixel circuit PC1 arranged in the second area AR2. The first display element DE1 and the fourth display element DE4 may be driven by the first pixel circuit PC1. The first pixel circuit PC1 may be connected to the first display element DE1 and the fourth display element DE4 through the circuit connection line PWL. For example, the first pixel circuit PC1 may be connected to the circuit connection line PWL through a contact hole provided in the third inorganic insulating layer 120, and the circuit connection line PWL may be connected to the first pixel electrode 2111 and the fourth pixel electrode 2114 through the first connection line CWL1.

The circuit connection line PWL may be located on the third inorganic insulating layer 120. The circuit connection line PWL may be connected to the first connection line CWL1 through a fourth connection electrode CM4 located on the fourth inorganic insulating layer 121. According to some embodiments, the circuit connection line PWL may be located on the fourth inorganic insulating layer 121, and the first connection line CWL1 may be directly connected to the circuit connection line PWL through a contact hole provided in the fifth inorganic insulating layer 122.

The circuit connection line PWL and the fourth connection electrode CM4 may each include a transparent conductive material. As an example, the circuit connection line PWL and the fourth connection electrode CM4 may include a transparent conductive oxide (TCO). The circuit connection line PWL may include a conductive oxide such as indium tin oxide (ITO), indium zinc oxide (IZO), zinc oxide (ZnO), indium oxide (In₂O₃), indium gallium oxide (IGO), or aluminum zinc oxide (AZO).

The first connection line CWL1 may be in direct contact with at least a portion of the first pixel electrode 2111 and the fourth pixel electrode 2114. Referring to FIG. 7, the first connection line CWL1 may be in contact with the lower surface of the first pixel electrode 2111 and the fourth pixel electrode 2114. The fourth pixel electrode 2114 of the fourth display element DE4 may be electrically connected to the first pixel electrode 2111 of the first display element DE1 through the first connection line CWL1. Because the first connection line CWL1 is in direct contact with the lower surface of the first pixel electrode 2111 and the fourth pixel electrode 2114, the first display element DE1 and the fourth display element DE4 may be electrically connected to the first pixel circuit PC1. Accordingly, an additional mask for forming the first connection line CWL1 may not be required. That is, the number of masks required in a process of manufacturing the display apparatus 1 may be reduced.

In addition, the first connection line CWL1 may be in contact with the first pixel electrode 2111 and the fourth pixel electrode 2114 and separately provided. Accordingly, the first connection line CWL1 may be controllable separately from the first pixel electrode 2111 and the fourth pixel electrode 2114. As an example, a resistance of the first connection line CWL1 may be controllable separately from the first pixel electrode 2111 and the fourth pixel electrode 2114.

The first connection line CWL1 may be located between the fifth inorganic insulating layer 122, and the first pixel electrode 2111 and the fourth pixel electrode 2114. According to some embodiments, in the case where the fifth inorganic insulating layer 122 and the fourth connection electrode CM4 are not provided, the first connection line CWL1 may be located between the fourth inorganic insulating layer 121, and the first pixel electrode 2111 and the fourth pixel electrode 2114.

The first connection line CWL1 may include a transparent conductive oxide (TCO). As an example, the first connection line CWL1 may include the poly indium tin oxide (poly-ITO).

According to some embodiments, as shown in FIG. 7, the organic insulating layer OIL in the second area AR2 may not be arranged in the first area AR1. The inorganic insulating layer IIL extending from the second area AR2 and the fifth inorganic insulating layer 122 on the inorganic insulating layer IIL may be located in the first area AR1. Because an organic layer has a stronger light absorption characteristic than an inorganic layer, a light transmittance may be reduced. Because the insulating layer in the first area AR1 includes the inorganic insulating layer IIL and the fifth inorganic insulating layer 122, a light transmittance may be improved.

According to some embodiments, the seventh display element 200b and the eighth display element 200c may be electrically connected to the second pixel circuit PC2 arranged in the second area AR2. The seventh display element 200b and the eighth display element 200c may be driven by the second pixel circuit PC2. As an example, as shown in FIG. 7, the second pixel circuit PC2 may be connected to the seventh pixel electrode 211b shared by the seventh display element 200b and the eighth display element 200c through a third connection electrode CM3.

The connection electrode CM3 may be located on the first organic insulating layer OIL1. The third connection electrode CM3 may include a material having a high conductivity. The third connection electrode CM3 may include a conductive material including molybdenum (Mo), aluminum (Al), copper (Cu), and titanium (Ti) and have a single-layered structure or a multi-layered structure including the above materials. According to some embodiments, the third connection electrode CM3 may have a multi-layered structure of Ti/Al/Ti.

According to some embodiments, the pixel-defining layer 215 may include an opening 215OP. The opening 215OP may expose a portion of the seventh pixel electrode 211b and another portion of the seventh pixel electrode 211b. The opening 215OP may expose a portion of the first pixel electrode 2111 and the fourth pixel electrode 2114. The opening 215OP may define the first emission area of the first display element DE1 and the fourth emission area of the fourth display element DE4.

In the first area AR1, the pixel-defining layer 215 may cover the edge 2111e of the first pixel electrode 2111 and the edge 2114e of the fourth pixel electrode 2114. The pixel-defining layer 215 may cover the edge CWL1e of the first connection line CWL1. The pixel-defining layer 215 may be in direct contact with a portion of the first connection line CWL1. In the first area AR1, the pixel-defining layer 215 may include an inorganic insulating material such as silicon nitride, silicon oxynitride, or silicon oxide.

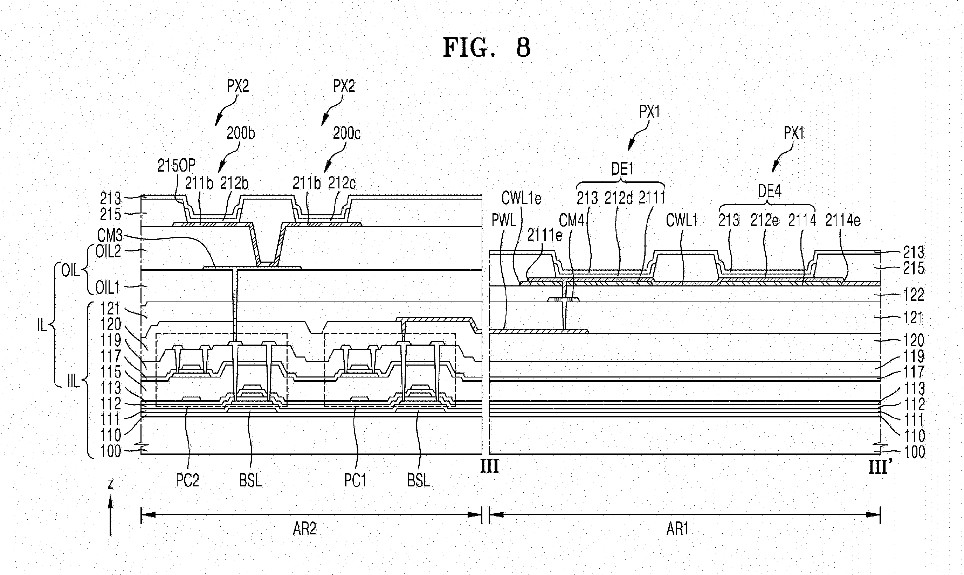

FIG. 8 is a cross-sectional view of an example of a portion of the display panel 10 in FIG. 6, taken along the line III-III' in FIG. 6. For example, FIG. 8 is a cross-sectional view of an example of a portion of the second area AR2 of FIG. 4, and a cross-sectional view of an example of a portion of the first area AR1 of FIG. 6, taken along the line III-III' of FIG. 6. In FIG. 8, the same reference numerals as those of FIG. 6 denote the same members, and thus, repeated descriptions thereof are omitted.

According to some embodiments, the first connection line CWL1 may be located on the lower surface of the first pixel electrode 2111 and the fourth pixel electrode 2114. The first connection line CWL1 may be in direct contact with the first pixel electrode 2111 and the fourth pixel electrode 2114. The first connection line CWL1 may be connected to the first pixel circuit PC1 by the circuit connection line PWL, and the first pixel electrode 2111 and the fourth pixel electrode 2114 are in contact with the first connection line CWL1. Accordingly, the first display element DE1 and the fourth display element DE4 may be driven by the first pixel circuit PC1.

Referring to FIG. 8, the edge 2111e of the first pixel electrode 2111 and the edge 2114e of the fourth pixel electrode 2114 may be located inside the edge CWL1e of the first connection line CWL1. Unlike this, a portion of the edge 2111e of the first pixel electrode 2111 and a portion of the edge 2114e of the fourth pixel electrode 2114 may be located outside the edge CWL1e of the first connection line CWL1.

In the case where the first connection line CWL1 is located on the first pixel electrode 2111 and the fourth pixel electrode 2114, the first pixel electrode 2111 and the fourth pixel electrode 2114 may be formed before the first connection line CWL1. Accordingly, an operation of curing a first material layer CWL1P described below may be omitted. The first connection line CWL1 may include a transparent conductive oxide (TCO). As an example, the first connection line CWL1 may include amorphous indium tin oxide (a-ITO).

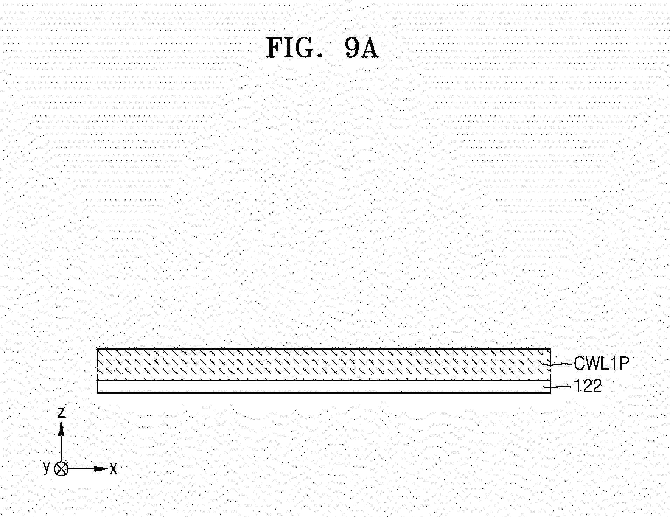

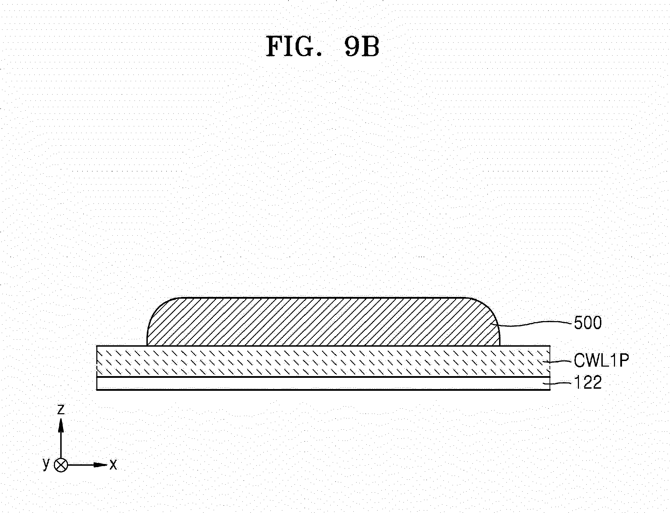

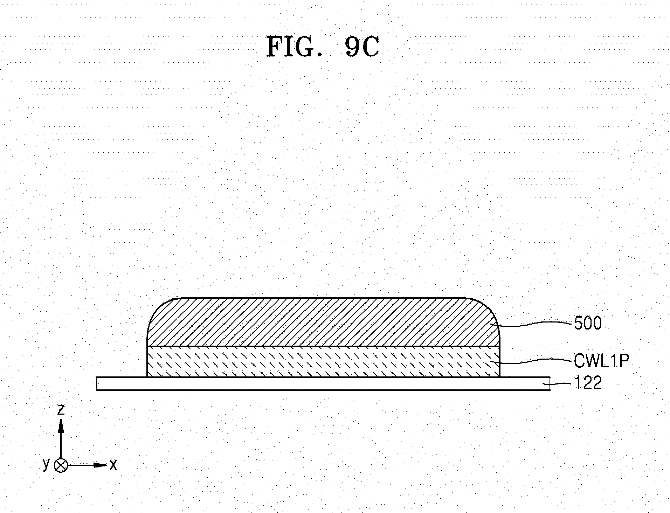

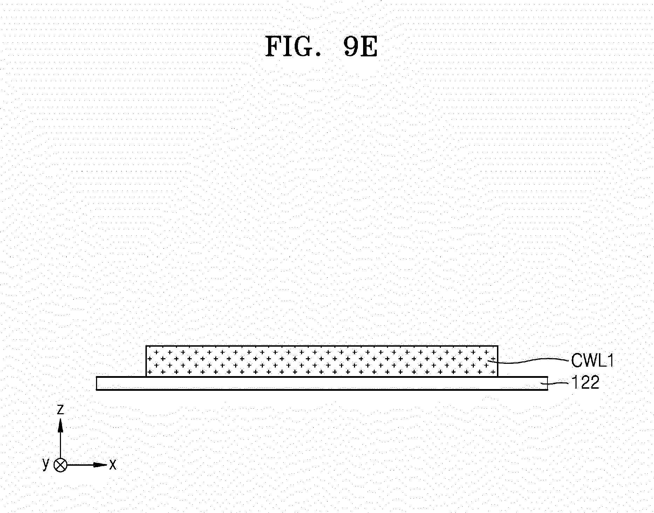

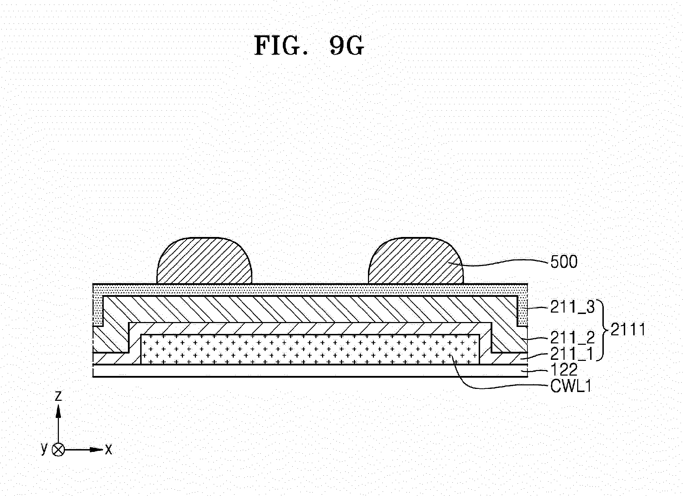

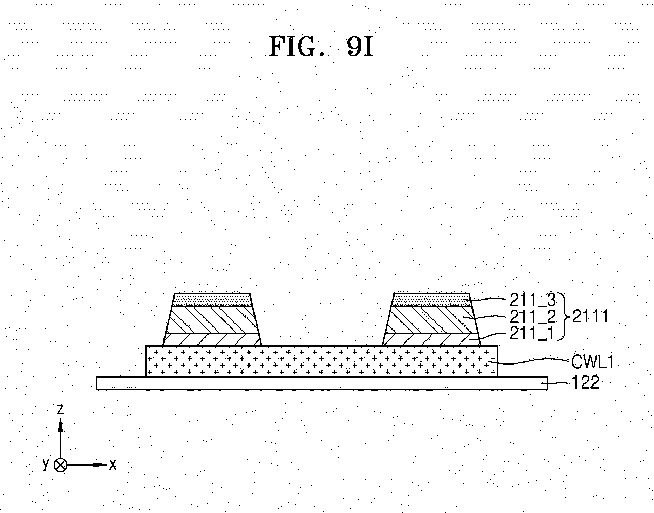

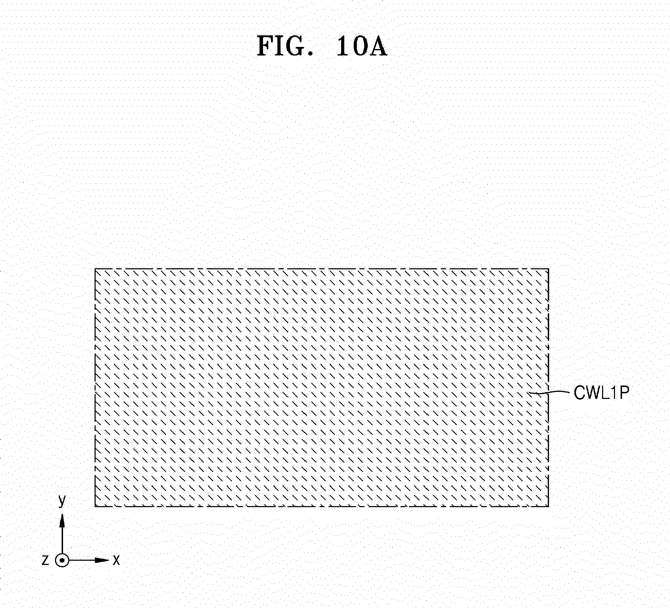

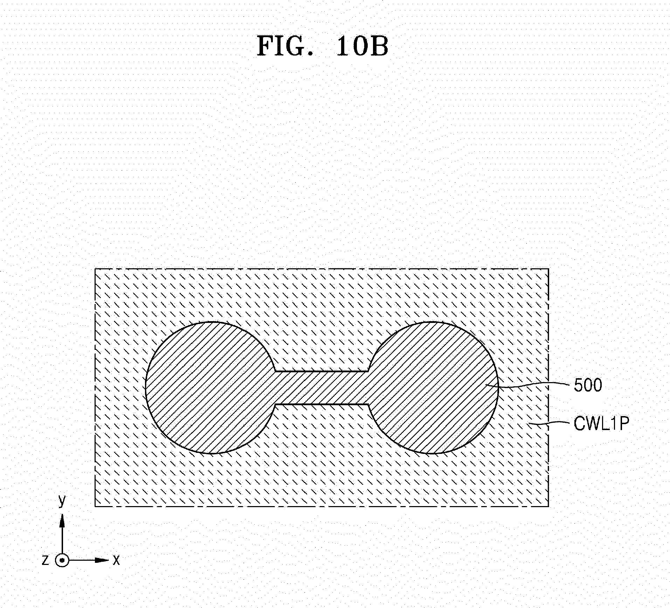

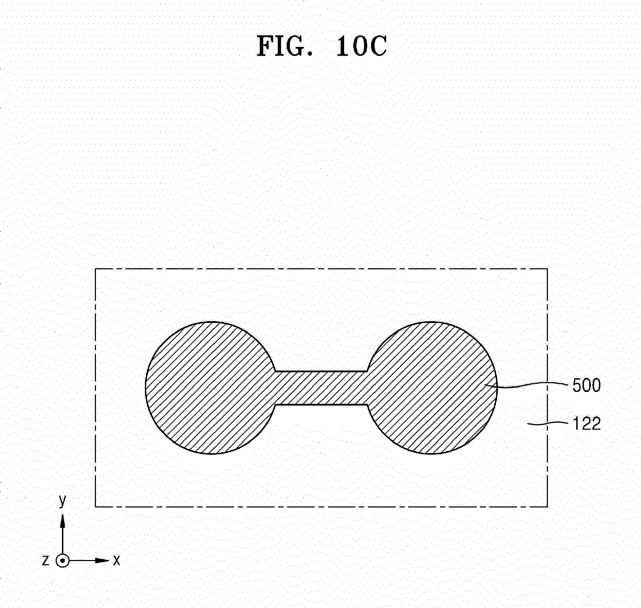

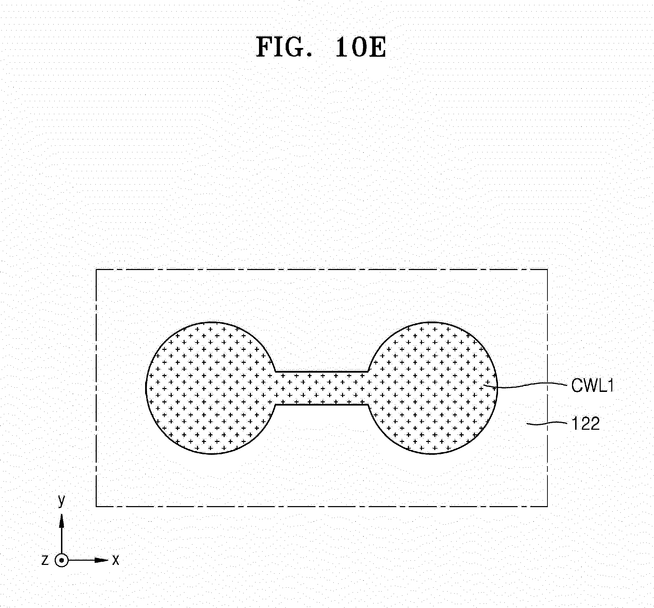

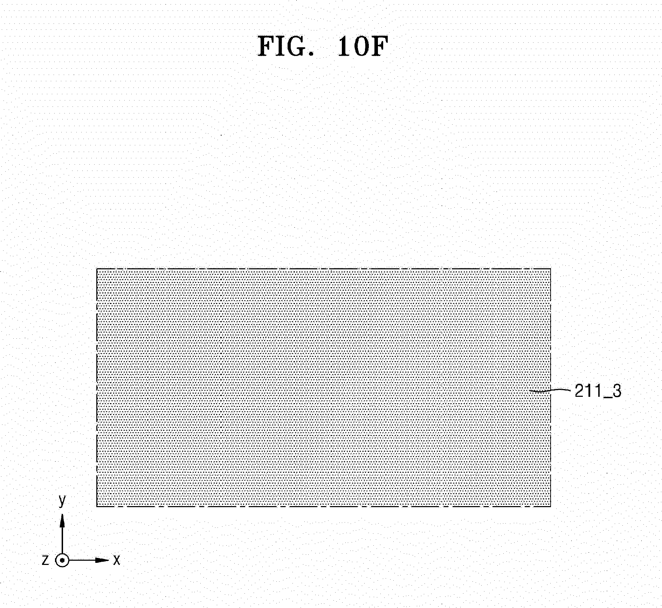

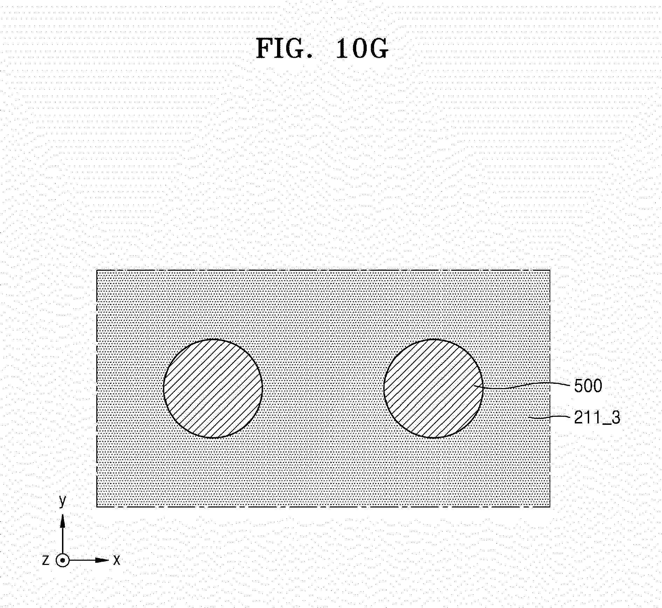

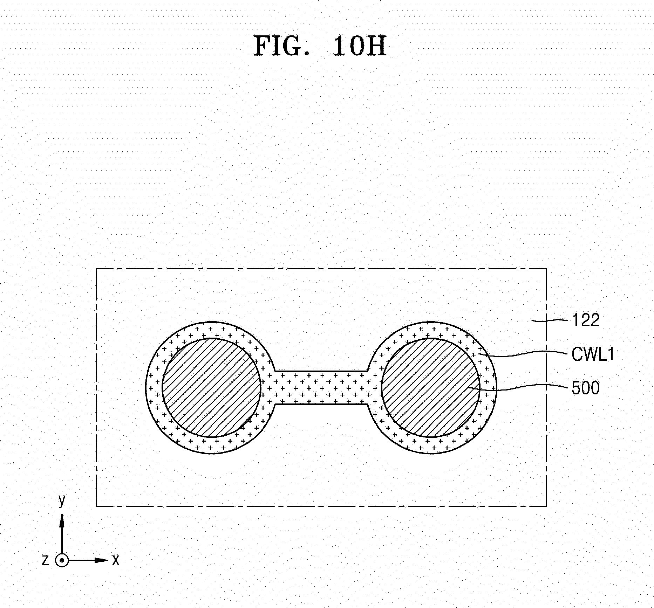

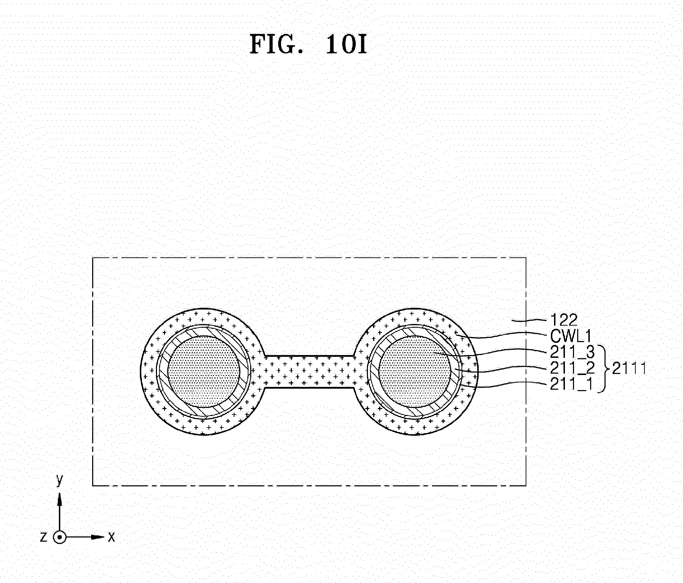

FIGS. 9A to 9I are schematic cross-sectional views sequentially showing a method of manufacturing a display apparatus according to some embodiments, and FIGS. 10A to 101 are schematic plan views sequentially showing a method of manufacturing a display apparatus according to some embodiments. In FIGS. 9A to 101, the same reference numerals as those of FIG. 7 denote the same members, and thus, repeated descriptions thereof are omitted.

Referring to FIGS. 9A to 9C and FIGS. 10A to 10C, the first material layer CWL1P may be formed on the inorganic layer, and then, the first material layer CWL1P may be formed in a specific pattern through a photolithography process that uses a photo mask 500, and a wet etching process. For convenience, the case where the inorganic layer is the fifth inorganic insulating layer 122 is described.

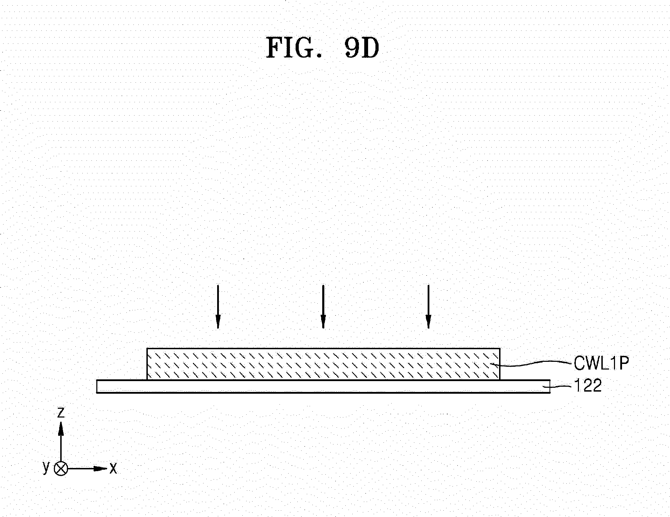

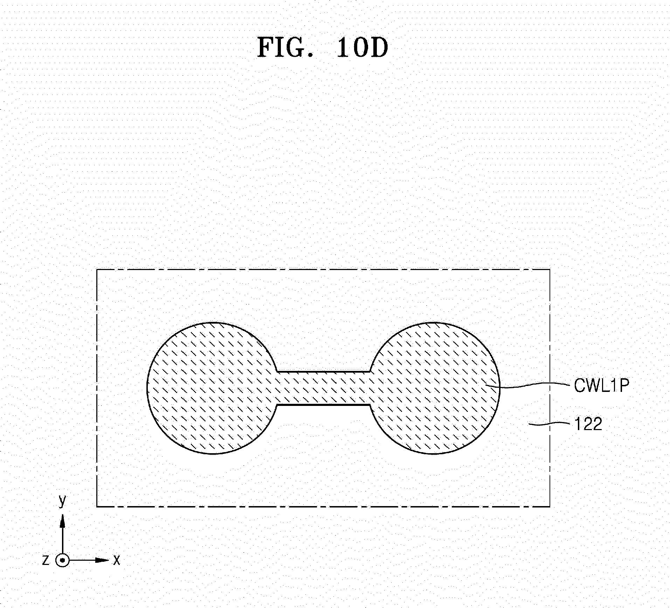

Next, referring to FIGS. 9D to 9E and FIGS. 10D to 10E, the first connection line CWL1 may be formed by curing the first material layer CWL1P. The curing of the first material layer CWLP may be performed at temperature of 200 °C or more. Accordingly, the first material layer CWL1P may change into a material protected during the wet etching process afterwards. As an example, in the case where the first material layer CWL1P include amorphous indium tin oxide (a-ITO), the first material layer CWL1P may change into poly-indium tin oxide (poly-ITO) during the curing process.

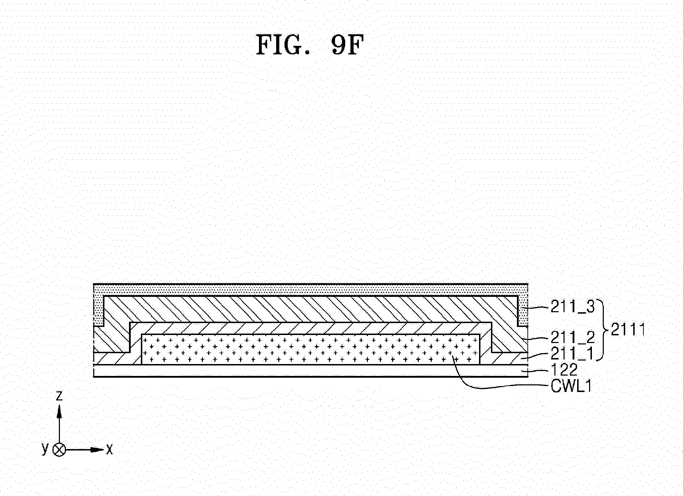

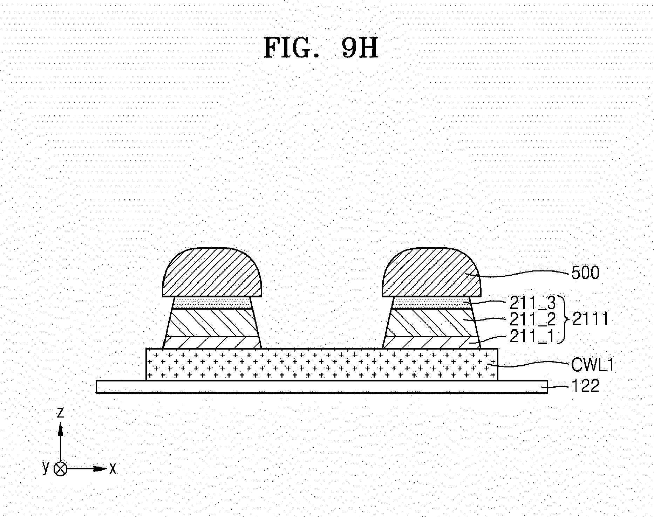

Referring to FIGS. 9F to 9I and FIGS. 10F to 101, the first pixel electrode 2111 may be formed on the first connection line CWL1 through the photolithography process and the wet etching process. The first pixel electrode 2111 may have a three-layered structure of a first layer 211_1, a second layer 211_2, and a third layer 211_3. The first layer 211_1 may be in direct contact with the first connection line CWL1. Referring to FIG. 9H, despite the wet etching process for forming the first pixel electrode 2111, the first connection line CWL1 may maintain its shape. In the case where the curing operation in FIG. 9D is not included, a portion of the first connection line CWL1 may be removed by the etching process for forming the first pixel electrode 2111. As an example, because the central portion of the first connection line CWL1 is removed by an etching solution and the first connection line CWL1 is separated, the fourth pixel electrode 2114 (see FIG. 7) cannot be electrically connected to the circuit connection line PWL (see FIG. 7).

According to some embodiments, because the first material layer CWL1P includes the curing process, even when the first pixel electrode 2111 and the fourth pixel electrode 2114 are directly formed on the first connection line CWL1, the first connection line CWL1 may be protected. For simplification of the drawing, although the first pixel electrode 2111 is described as an example, the fourth pixel electrode 2114 may be simultaneously (or concurrently) formed with the first pixel electrode 2111 by the same method. In addition, the description for the first connection line CWL1 and the first pixel electrode 2111 is equally applicable to the second connection line CWL2, the second pixel electrode 2112, the third connection line CWL3, and the third pixel electrode 2113.

Up to this point, although description has been mainly made to the display apparatus, the embodiments are not limited thereto. As an example, a method of manufacturing a display apparatus to manufacture the display apparatus also falls within the scope of embodiments according to the present disclosure.

The electronic or electric devices and/or any other relevant devices or components according to embodiments of the present invention described herein may be implemented utilizing any suitable hardware, firmware (e.g. an application-specific integrated circuit), software, or a combination of software, firmware, and hardware. For example, the various components of these devices may be formed on one integrated circuit (IC) chip or on separate IC chips. Further, the various components of these devices may be implemented on a flexible printed circuit film, a tape carrier package (TCP), a printed circuit board (PCB), or formed on one substrate. Further, the various components of these devices may be a process or thread, running on one or more processors, in one or more computing devices, executing computer program instructions and interacting with other system components for performing the various functionalities described herein. The computer program instructions are stored in a memory which may be implemented in a computing device using a standard memory device, such as, for example, a random access memory (RAM). The computer program instructions may also be stored in other non-transitory computer readable media such as, for example, a CD-ROM, flash drive, or the like. Also, a person of skill in the art should recognize that the functionality of various computing devices may be combined or integrated into a single computing device, or the functionality of a particular computing device may be distributed across one or more other computing devices without departing from the scope of the embodiments of the present invention.

According to some embodiments, the display apparatus that may be capable of maintaining a relatively high resolution while maintaining a relatively high transmittance may be implemented. However, the scope of embodiments according to the present disclosure is not limited by this effect.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the scope as defined by the following claims, and their equivalents.

## Claims

1. A display apparatus comprising:
a first display element configured to emit light of a first color and including a first pixel electrode;
a second display element configured to emit light of a second color different from the first color, and including a second pixel electrode;
a third display element configured to emit light of a third color different from the first color and the second color, and including a third pixel electrode;
a fourth display element configured to emit light of the first color and including a fourth pixel electrode; and
a first connection line connecting the first pixel electrode and the fourth pixel electrode to each other, the first connection line directly contacting the first pixel electrode and the fourth pixel electrode.

2. The display apparatus of claim 1, wherein, in a plan view, an edge of the first connection line surrounds an edge of the first pixel electrode and an edge of the fourth pixel electrode.

3. The display apparatus of claim 1 or 2, wherein the first pixel electrode and the fourth pixel electrode are on the first connection line, and optionally
wherein the first connection line includes poly indium tin oxide.

4. The display apparatus of any one of claims 1 to 3, wherein the first connection line covers the first pixel electrode and the fourth pixel electrode.

5. The display apparatus of any one of claims 1 to 4, further comprising a pixel-defining layer including an opening exposing at least a portion of each of the first to fourth display elements, directly contacting the first connection line partially, and including an inorganic material.

6. The display apparatus of any one of claims 1 to 5, further comprising:
a substrate including a first region and a second region adjacent to each other;
a pixel circuit in the second region and configured to drive the first display element and the fourth display element;
a circuit connection line electrically connected to the pixel circuit and extending from the second region to the first region; and
an inorganic insulating layer covering the circuit connection line and extending from the second region to the first region,
wherein the first connection line is on the inorganic insulating layer, and
the first connection line, the first pixel electrode, and the fourth pixel electrode are in the first region, and optionally
wherein the circuit connection line and the first connection line each include a transparent conductive material.

7. The display apparatus of any one of claim 1, further comprising:
a fifth display element configured to emit light of the second color and including a fifth pixel electrode; and
a second connection line connecting the second pixel electrode and the fifth pixel electrode to each other,
wherein the first display element and the third display element are arranged in a first direction, and the second display element and the fifth display element are arranged in a second direction crossing the first direction, and optionally
further comprising:
a sixth display element configured to emit light of the third color and including a sixth pixel electrode; and
a third connection line connecting the third pixel electrode and the sixth pixel electrode to each other,
wherein the third display element and the sixth display element are arranged in the first direction.

8. A method of manufacturing a display apparatus, the method comprising:
forming a first display element configured to emit light of a first color and including a first pixel electrode;
forming a second display element configured to emit light of a second color different from the first color, and including a second pixel electrode;
forming a third display element configured to emit light of a third color different from the first color and the second color, and including a third pixel electrode;
forming a fourth display element configured to emit light of the first color and including a fourth pixel electrode; and
forming a first connection line by curing a first material layer,
wherein the first connection line connects the first pixel electrode and the fourth pixel electrode to each other and contacts lower surfaces of the first pixel electrode and the fourth pixel electrode.

9. The method of claim 8, wherein the forming of the first connection line is performed before the first pixel electrode and the fourth pixel electrode are formed.

10. The method of claim 8 or 9, wherein the first connection line includes a transparent conductive material, and optionally
wherein the first material layer includes amorphous indium tin oxide, and
the first connection line includes poly indium tin oxide.

11. The method of any one of claims 8 to 10, wherein the curing of the first material layer is performed at temperature of 200 °C or more.

12. The method of any one of claims 8 to 11, wherein, in a plan view, an edge of the first connection line surrounds an edge of the first pixel electrode and an edge of the fourth pixel electrode.

13. The method of any one of claims 8 to 12, further comprising:
forming a substrate including a first region and a second region adjacent to each other;
forming a pixel circuit in the second region and configured to drive the first display element and the fourth display element;
forming a circuit connection line electrically connected to the pixel circuit and extending from the second region to the first region; and
forming an inorganic insulating layer covering the circuit connection line and extending from the second region to the first region,
wherein the first connection line, the first pixel electrode, and the fourth pixel electrode are in the first region, and optionally
wherein the forming of the circuit connection line is performed before the forming of the first connection line.

14. The method of any one of claims 8 to 13, further comprising:
forming a fifth display element configured to emit light of the second color and including a fifth pixel electrode; and
forming a second connection line connecting the second pixel electrode and the fifth pixel electrode to each other,
wherein the first display element and the third display element are arranged in a first direction, and the second display element and the fifth display element are arranged in a second direction crossing the first direction.

15. The method of any one of claims 8 to 14, further comprising forming a pixel-defining layer including an opening exposing at least a portion of each of the first to fourth display elements, directly contacting the first connection line partially, and including an inorganic material.
